(19) Europäisches Patentamt
European Patent Office
Office européen des brevets

(11) Publication number: **0 610 936 A2**

(12) **EUROPEAN PATENT APPLICATION**

(21) Application number: **94102076.0**

(51) Int. Cl.[5]: **G03F 7/07**

(22) Date of filing: **10.02.94**

(30) Priority: **10.02.93 JP 44355/93**

(43) Date of publication of application:
**17.08.94 Bulletin 94/33**

(84) Designated Contracting States:
**BE CH GB LI**

(71) Applicant: **FUJI PHOTO FILM CO., LTD.**
**210 Nakanuma**
**Minami-Ashigara-shi**
**Kanagawa (JP)**

(72) Inventor: **Takagi, Yoshihiro**
**c/o Fuji Photo Film CO.,Ltd.,**
**210, Nakanuma**
**Minami-ashigara-shi, Kanagawa (JP)**

(74) Representative: **Patentanwälte Grünecker,**
**Kinkeldey, Stockmair & Partner**
**Maximilianstrasse 58**
**D-80538 München (DE)**

(54) **Lithographic printing material.**

(57) A lithographic printing plate material utilized for silver salt diffusion transfer includes an undercoat layer containing a solid particle dispersion of a dyestuff, a silver halide emulsion layer, and a physical development nucleus layer on a support. It exhibits high sensitivity, high resolving power and good printability.

EP 0 610 936 A2

## BACKGROUND OF THE INVENTION

### Field of the Invention

This invention relates to a silver salt lithographic printing material intended for producing positive and negative transfer silver images. More particularly, it relates to a silver salt lithographic printing material utilized for laser exposure and silver salt diffusion transfer and exhibiting improved photographic properties, minimized scumming, improved ink receptivity and printing endurance.

### Prior Art

There are known in the prior art a number of lithographic printing materials utilizing silver salt diffusion transfer. Typical printing materials have integrated together a photographic element having photosensitivity and a printing image element in the form of a physical development nucleus layer as disclosed in, for example, Japanese Patent Publication (JP-B) No. 42453/1971 and 30562/1973. They use conventional negative emulsions so that transferred silver images are positive.

In accordance with the recent advance of the computer technology, attention is now paid to the direct process wherein printing plates are directly exposed to final images through an image setter using a laser or light-emitting diode light source. For further increasing resolving power upon laser scanning exposure, it is desired to enhance anti-halation ability.

Systems for producing a transferred silver image as a negative image are also described in JP-B 13587/1986, 06108/1982, and 26019/1981, and Japanese Patent Unexamined Publication (JP-A) No. 173247/1986. These systems, however, are unacceptable in practice because of low sensitivity, shortage of transferred silver, and unsatisfactory properties as printing plates including ink receptivity, plate wear (also known as printing endurance or run length), and scumming (also known as toning).

In the case of scanning exposure by laser or the like, a lithographic printing material designed to produce a transferred silver image of the negative type has the reduced risk of scumming because the only requirement is to expose image portions including characters, dots and lines and thus the exposed area is small. Another advantage is ease of matching with output machines such as image setters among which the negative output type is predominant. However, in practice, there are available no acceptable lithographic printing materials of the negative type because none of then can satisfy the requirements of sensitivity and printing characteristics.

One method for producing transfer silver images of the negative type uses direct reversal emulsions. The direct reversal emulsions include pre-fogged emulsions and internal latent image type emulsions. The pre-fogged emulsions have the drawbacks that sensitivity is low, it is difficult to render them red and infrared sensitive, no reversal image is available if a developing agent is incorporated therein, and they cannot be treated with activators which are substantially free of a developing agent. The internal latent image type emulsions are described in US Patent Nos. 2,466,957, 2,497,875, 2,588,982, 2,592,250, 3,317,322, 3,761,266, 3,761,276, and 3,796,577. They have high sensitivity, but suffer from the drawback that reversal becomes difficult with a developer containing a silver halide solvent.

Japanese Patent Application No. 331072/1992 proposes a method for producing satisfactory negative transfer images using such a direct reversal emulsion. It is still desired to enhance anti-halation ability in order to increase resolving power.

The anti-halation ability can be enhanced by the use of an undercoat layer. In JP-A 13249/1986, 196548/1983, and 259666/1988, it is proposed to add a matte agent such as silica to hydrophilic colloid such as gelatin in an undercoat layer and dispersing carbon black therein for anti-halation purpose. Carbon black, however, has several problems. A large count of carbon black must be added for preventing halation upon laser light scanning exposure, resulting in a lowering of film quality and plate wear. Impurities in carbon black would exacerbate the shelf life of the plate material.

Such problems are eliminated by using conventional water-soluble dyes instead of carbon black for anti-halation purpose, but the water-soluble dyes can diffuse into the emulsion layer to lower its sensitivity.

It is thus desired to develop an effective means capable of fixing a coloring agent, which is effective for anti-halation in small amounts, in an undercoat layer without adversely affecting shelf stability.

## SUMMARY OF THE INVENTION

Therefore, an object of the present invention is to provide a lithographic printing material for producing a negative or positive transfer silver image utilizing silver salt diffusion transfer, the material featuring high

sensitivity, high resolving power, improved plate wear and ink receptivity. Another object is to provide a lithographic printing material which is compatible with a high illuminance light source such as laser light of a particular wavelength and adaptable to various processing systems.

According to the present invention, there is provided a lithographic printing material adapted for silver salt diffusion transfer comprising at least an undercoat layer, a silver halide emulsion layer, and a physical development nucleus layer on a support, characterized in that the undercoat layer contains a solid particle dispersion of a dyestuff.

BEST MODE FOR CARRYING OUT THE INVENTION

The solid particle dispersion of a dyestuff may be selected from those disclosed in JP-A 12639/1981, 155350/1980, 155351/1980, 27838/1988, and 197943/1988, EP 15,601, 274,723, 276,566, and 299,435 and WO 88/04794.

Preferably the dyestuff is at least one compound selected from compounds of the following general formulae (I) through (VII).

(I)

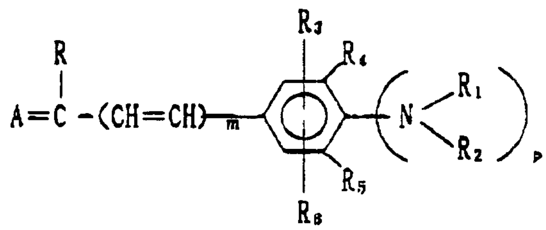

(II)

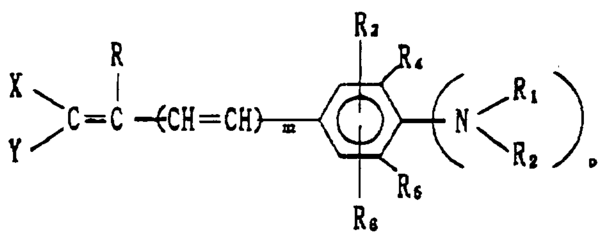

(III)

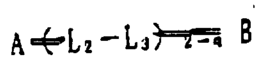

(IV)

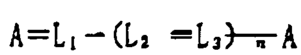

(V) 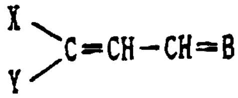

In formulae (I) to (V), each of A and A' which may be identical or different is an acidic nucleus, B is a basic nucleus, and each of X and Y which may be identical or different is an electron attractive group. R is a hydrogen atom or alkyl group, each of $R_1$ and $R_2$ is an alkyl, aryl, acyl or sulfonyl group, or $R_1$ and $R_2$ taken together may form a five or six-membered ring. Each of $R_3$ and $R_6$ is a hydrogen atom, alkyl group, hydroxyl group, carboxyl group, alkoxy group or halogen atom, each of $R_4$ and $R_5$ is a hydrogen atom, or $R_1$ and $R_4$ or $R_2$ and $R_5$ taken together represent a group of non-metallic atoms necessary to form a five or six-membered ring Each of $L_1$, $L_2$, and $L_3$ is a methine group. Letter m is equal to 0 or 1, n is equal to 0, 1 or 2, p is equal to 0 or 1, and q is equal to 0, 1 or 2. When p is 0, $R_3$ is a hydroxyl or carboxyl group and $R_4$ and $R_5$ are hydrogen atoms.

Each of the compounds of general formulae (I), (II), (III), (IV), and (V) has in a molecule at least one dissociatable group having a pKa of 4 to 11 in a mixture of water and ethanol in a volume ratio of 1:1.

The dissociatable proton-bearing group having a pKa (acid dissociation constant) of 4 to 11 in a water/ethanol 1/1 (volume ratio) mixture is not limited in type and position of substitution on a dyestuff molecule as long as it renders the dyestuff molecule substantially water insoluble at pH 6 or lower, but substantially water soluble at pH 8 or higher. Preferably it is a carboxyl, sulfamoyl, sulfonamide or hydroxyl group, with the carboxyl group being most preferred. The dissociatable group may substitute on the dyestuff molecule directly or through a divalent linkage (e.g., alkylene and phenylene group). Examples of the dissociatable group substituting on the dyestuff molecule through a divalent linkage include 4-carboxyphenyl, 2-methyl-3-carboxyphenyl, 2,4-dicarboxyphenyl, 3,5-dicarboxyphenyl, 3-carboxyphenyl, 2,5-dicarboxyphenyl, 3-ethylsulfamoylphenyl, 4-phenylsulfamoylphenyl, 2-carboxyphenyl, 2,4,6-trihydroxyphenyl, 3-benzenesulfonamidophenyl, 4-(p-cyanobenzenesulfonamido)phenyl, 3-hydroxyphenyl, 2-hydroxyphenyl, 4-hydroxyphenyl, 2-hydroxy-4-carboxyphenyl, 3-methoxy-4-carboxyphenyl, 2-methyl-4-phenylsulfamoylphenyl, 4-carboxybenzyl, 2-carboxybenzyl, 3-sulfamoylphenyl, 4-sulfamoylphenyl, 2,5-disulfamoylphenyl, carboxymethyl, 2-carboxyethyl, 3-carboxypropyl, 4-carboxybutyl, and 8-carboxyoctyl.

The compounds of general formulae (I), (II), (III), (IV), and (V) are described in further detail.

The acidic nucleus represented by each of A and A' is preferably 2-pyrazolin-5-one, rhodanine, hydantoin, thiohydantoin, 2,4-oxazolidinedione, isooxazolidinone, barbituric acid, thiobarbituric acid, indanedione, pyrazolopyridone, or hydroxypyridone.

The basic nucleus represented by B is preferably pyridine, quinoline, indolenine, oxazole, benzoxazole, naphthoxazole, or pyrrole.

The alkyl group represented by R, $R_3$ or $R_6$ is preferably selected from alkyl groups having 1 to 10 carbon atoms, for example, methyl, ethyl, n-propyl, isoamyl, and n-octyl.

The alkyl group represented by $R_1$ or $R_2$ is preferably selected from alkyl groups having 1 to 20 carbon atoms, for example, methyl, ethyl, n-propyl, n-butyl, n-octyl, n-octadecyl, isobutyl and isopropyl, which may have a substituent or substituents, for example, halogen atoms (e.g. chloro and bromo), nitro groups, cyano groups, hydroxy groups, carboxyl groups, alkoxy groups (e.g., methoxy and ethoxy), alkoxycarbonyl groups (e.g., methoxycarbonyl and i-propoxycarbonyl), aryloxy groups (e.g., phenoxy), phenyl groups, amido groups (e.g., acetylamino and methanesulfonamido), carbamoyl groups (e.g., methylcarbamoyl and ethylcarbamoyl), and sulfamoyl groups (e.g., methylsulfamoyl and phenylsulfamoyl).

The aryl group represented by $R_1$ or $R_2$ is preferably selected from phenyl and naphthyl groups which may have a substituent or substituents, the substituent including the groups mentioned above as the substituent on the alkyl group represented by $R_1$ or $R_2$ and alkyl groups such as methyl and ethyl.

The acyl group represented by $R_1$ or $R_2$ is preferably selected from acyl groups having 2 to 10 carbon atoms, for example, acetyl, propionyl, n-octanoyl, n-decanoyl, isobutanoyl, and benzoyl groups. The alkylsulfonyl and arylsulfonyl groups represented by $R_1$ or $R_2$ include methanesulfonyl, ethanesulfonyl, n-butanesulfonyl, n-octanesulfonyl, benzenesulfonyl, p-toluenesulfonyl, and o-carboxybenzenesulfonyl groups.

The alkoxy group represented by $R_3$ or $R_6$ is preferably selected from alkoxy groups having 1 to 10 carbon atoms, for example, methoxy, ethoxy, n-butoxy, n-octoxy, 2-ethylhexyloxy, isobutoxy, and isopropoxy groups. The halogen atom represented by $R_3$ or $R_6$ is preferably selected from chlorine, bromine and fluorine.

The ring formed by $R_1$ and $R_4$ taken together or $R_2$ and $R_5$ taken together is a julolidine ring.

The five or six-membered ring formed by $R_1$ and $R_2$ taken together is selected from piperidine, morpholine, and pyrrolidine rings, for example.

The methine group represented by $L_1$, $L_2$ or $L_3$ may have a substituent, for example, methyl, ethyl, cyano, phenyl, chlorine atom and hydroxypropyl.

The electron attractive group represented by X and Y, which may be identical or different, is a cyano group, a carboxyl group, a substituted or unsubstituted alkylcarbonyl group (e.g., acetyl, propionyl, heptanoyl, dodecanoyl, hexadecanoyl, and 1-oxo-7-chloroheptyl), a substituted or unsubstituted arylcarbonyl group (e.g., benzoyl, 4-ethoxycarbonylbenzoyl, and 3-chlorobenzoyl), a substituted or unsubstituted alkoxycarbonyl group (e.g., methoxycarbonyl, ethoxycarbonyl, butoxycarbonyl, t-amyloxycarbonyl, hexyloxycarbonyl, 2-ethylhexyloxycarbonyl, octyloxycarbonyl, decyloxycarbonyl, dodecyloxycarbonyl, hexadecyloxycarbonyl, octadecyloxycarbonyl, 2-butoxyethoxycarbonyl, 2-methylsulfonylethoxycarbonyl, 2-cyanoethoxycarbonyl, 2-(2-chloroethoxy)ethoxycarbonyl, and 2-[2-(2-chloroethoxy)ethoxy]ethoxycarbonyl), a substituted or unsubstituted aryloxycarbonyl group (e.g., phenoxycarbonyl, 3-ethylphenoxycarbonyl, 4-ethylphenoxycarbonyl, 4-fluorophenoxycarbonyl, 4-nitrophenoxycarbonyl, 4-methoxyphenoxycarbonyl, and 2,4-di(t-amyl)-phenoxycarbonyl), a substituted or unsubstituted carbamoyl group (e.g., carbamoyl, ethylcarbamoyl, dodecylcarbamoyl, phenylcarbamoyl, 4-methoxyphenylcarbanoyl, 2-bromophenylcarbamoyl, 4-chlorophenylcarbamoyl, 4-ethoxycarbonylphenylcarbamoyl, 4-propylsulfonylphenylcarbamoyl, 4-cyanophenylcarbamoyl, 3-methylphenylcarbamoyl, 4-hexyloxyphenylcarbamoyl, 2,4-di(t-amyl)-phenylcarbamoyl, 2-chloro-3-(dodecyloxycarbonyl)phenylcarbanoyl, and 3-(hexyloxycarbonyl)-phenylcarbamoyl), a sulfonyl group (e.g., methylsulfonyl and phenylsulfonyl), and a substituted or unsubstituted sulfamoyl group (e.g., sulfamoyl and methylsulfamoyl).

**General formula (VI):**

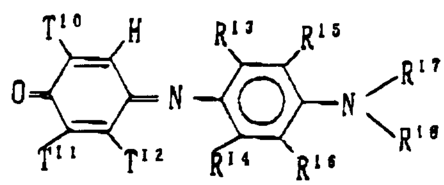

In the formula, $T^{10}$, $T^{11}$, and $T^{12}$ are independently selected from a hydrogen atom, halogen atom, cyano, nitro, carboxyl, alkyl, aryl, alkoxy, aryloxy, alkylthio, arylthio, alkylsulfonyl, arylsulfonyl, sulfamoyl, carbamoyl, amino, sulfonamido, carbonamido, ureido, sulfamido, hydroxy, vinyl, and acyl group. $R^{13}$ and $R^{14}$ are independently selected from a hydrogen atom, halogen atom, alkoxy, alkyl, alkenyl, aryloxy, and aryl group. $R^{15}$ and $R^{16}$ are independently selected from a hydrogen atom or a group substituting therefor. $R^{17}$ and $R^{18}$ are independently selected from an alkyl, aryl, vinyl, acyl, alkylsulfonyl, and arylsulfonyl group. Alternatively, each pair of $T^{11}$ and $T^{12}$, $R^{13}$ and $R^{15}$, $R^{14}$ and $R^{16}$, $R^{17}$ and $R^{18}$, $R^{15}$ and $R^{17}$, and $R^{16}$ and $R^{18}$, taken together, may form a ring.

**General formula (VII):**

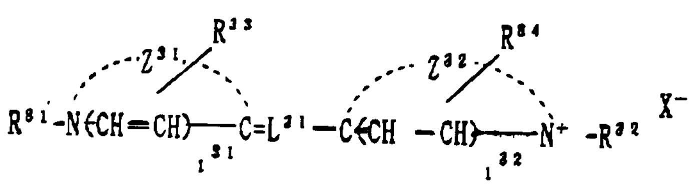

In the formula, each of $R^{31}$ and $R^{32}$ is an alkyl, alkenyl or aryl group, each of $R^{33}$ and $R^{34}$ is a hydrogen atom or a monovalent group, each of $Z^{31}$ and $Z^{32}$ is a group of non-metallic atoms necessary to form a five

or six-membered nitrogenous heterocyclic ring, $L^{31}$ is a linkage of five to seven methine groups concatenated through conjugated double bonds, $X^-$ is an anion, and each of $l^{31}$ and $l^{32}$ is equal to 0 or 1.

By the term "solid particle dispersion" of the compound according to the invention it is meant that since the compound itself has poor solubility, it cannot be present in a molecular state in an intended hydrophilic colloid layer, but present in a solid state having a size which cannot substantially diffuse in the layer.

Preparation methods are described in WO 88/04794, EP 0276566 A1, and JP-A 197943/1988 while it is a common practice to stabilize the dispersion with a surfactant and gelatin.

The preparation method used herein is in accord with the method of JP-A 197943/1988.

Preferably, the solid particle dispersion of the compound according to the invention has a particle size of up to 1.0 $\mu$m, more preferably up to 0.5 $\mu$m.

Preferably the compound is used in an amount of 5 mg/$m^2$ to 500 mg/$m^2$, especially 10 mg/$m^2$ to 250 mg/$m^2$ of a hydrophilic colloid layer which is an undercoat layer.

The hydrophilic colloid used herein is typically gelatin although any of conventional hydrophilic colloids known for photographic use may be employed. When gelatin is a hydrophilic colloid in a hydrophilic colloid layer, it is preferably used in an amount of up to 3.0 g/$m^2$, especially 0.2 g/$m^2$ to 1.5 g/$m^2$ of the hydrophilic colloid layer.

Illustrative, non-limiting, examples of the compounds of general formulae (I) to (VII) are given below.

I - 1

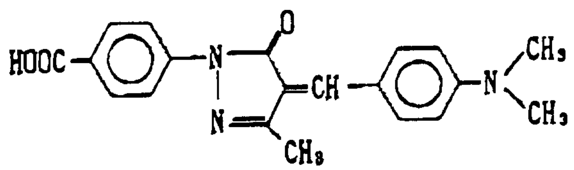

I - 2

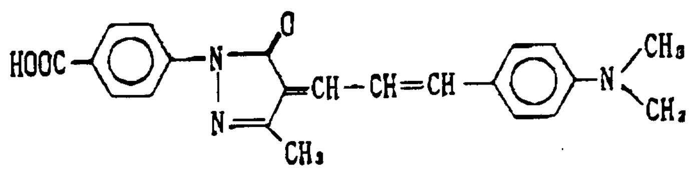

I - 3

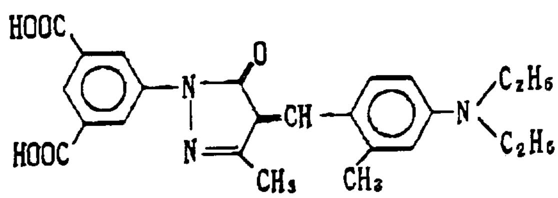

I − 4

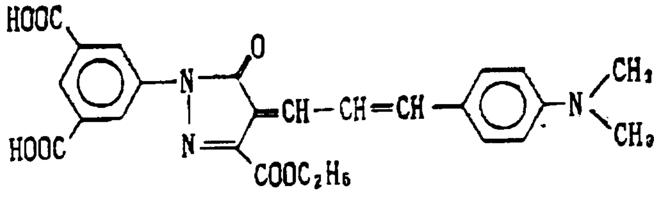

I − 5

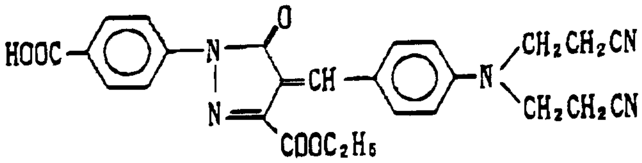

I − 6

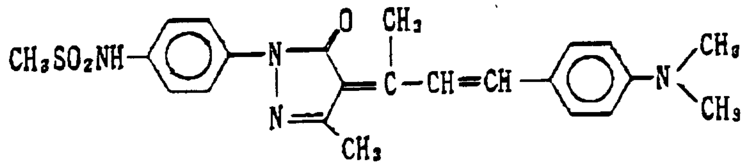

I − 7

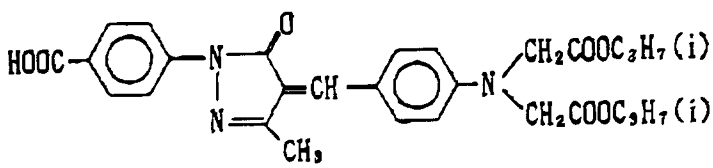

I − 8

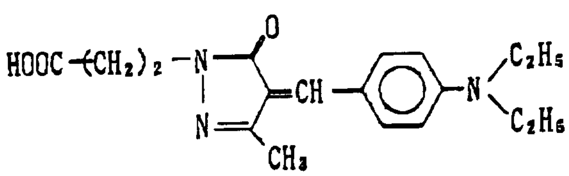

I-9

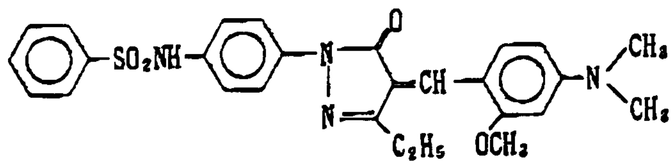

I-10

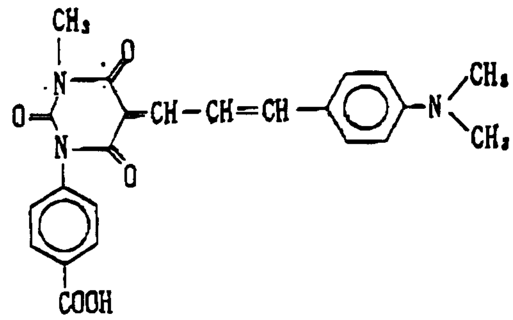

I-11

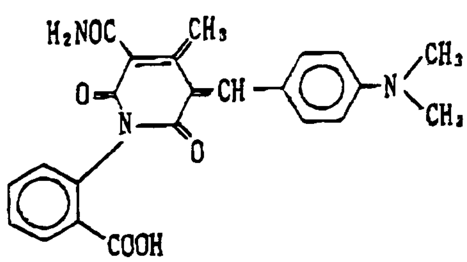

I-12

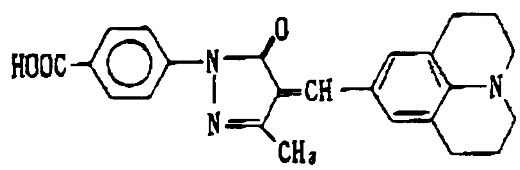

I-13

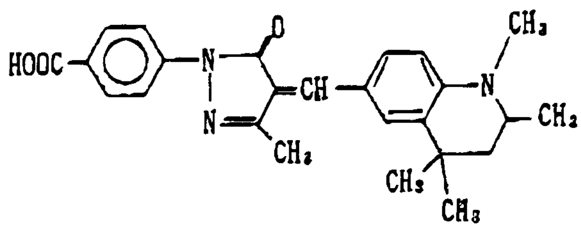

I-14

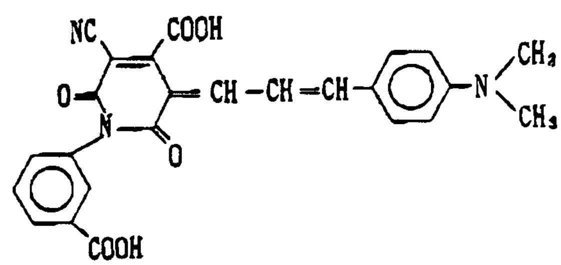

I－15

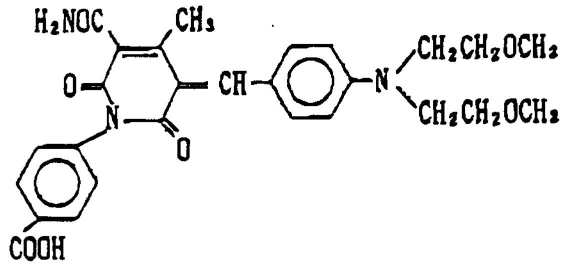

I－16

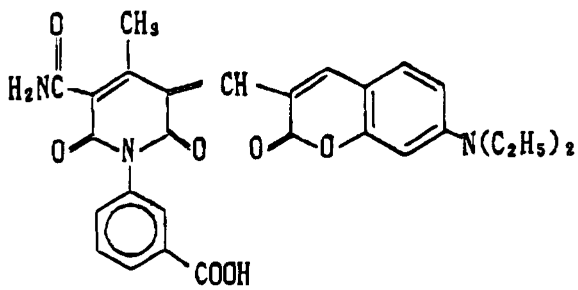

I－17

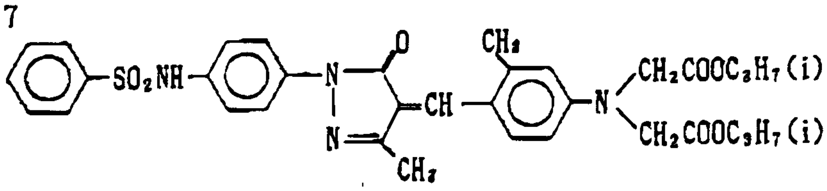

I－18

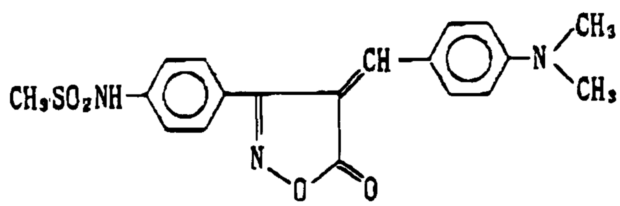

I－19

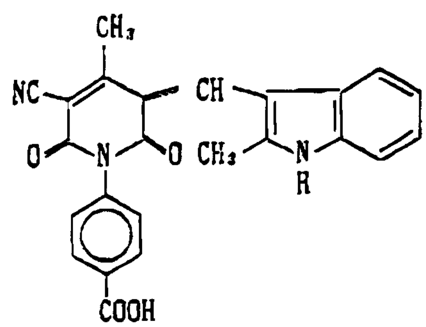

I－2 0

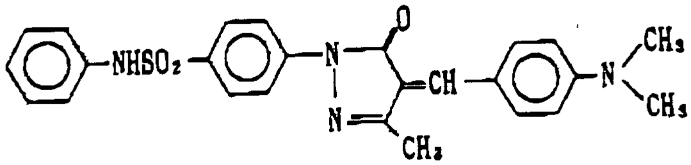

I－2 1

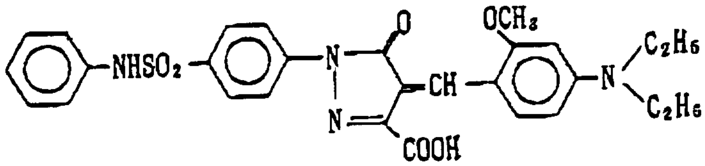

I－2 2

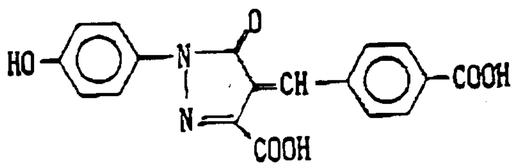

I－2 3

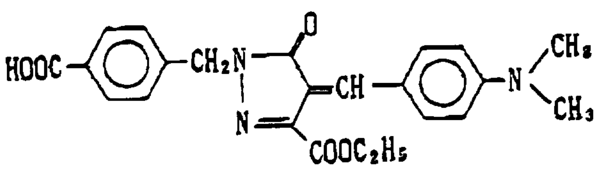

I－2 4

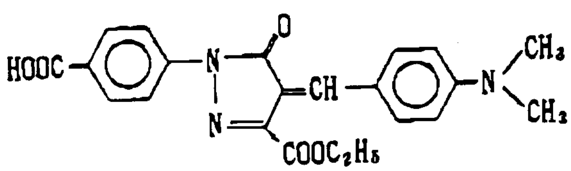

I-25

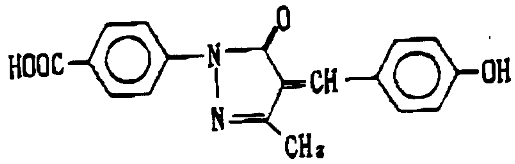

I-26

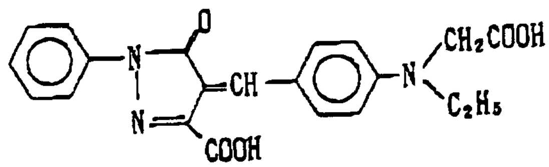

I-27

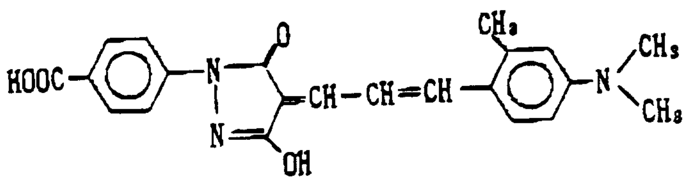

I-28

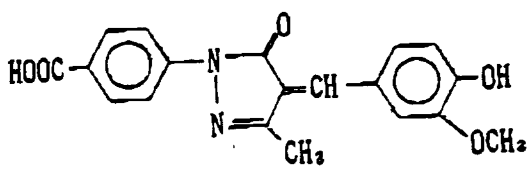

II－1

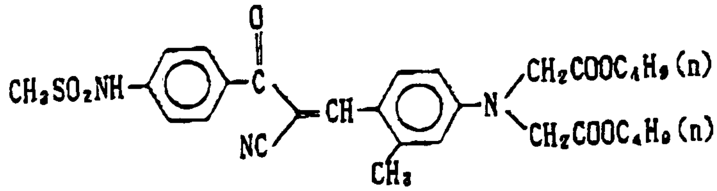

II－2

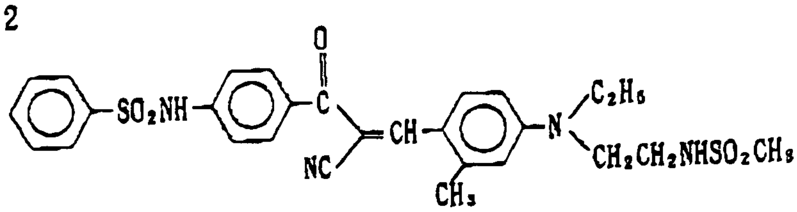

II－3

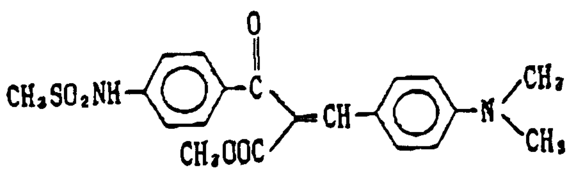

II－4

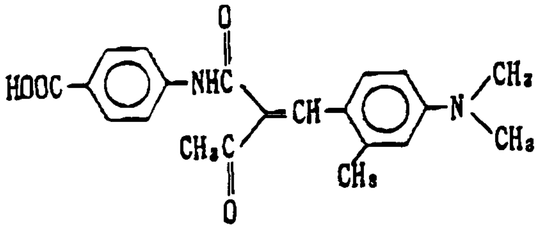

II－5

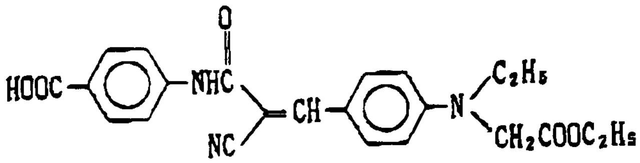

II－6

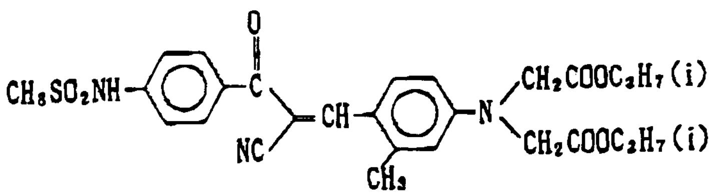

II－7

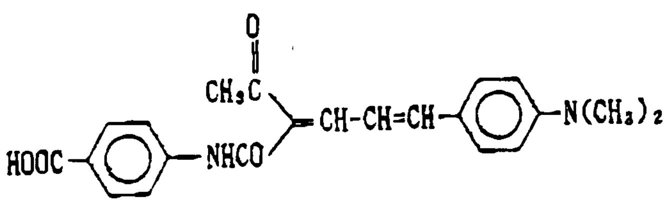

III-1

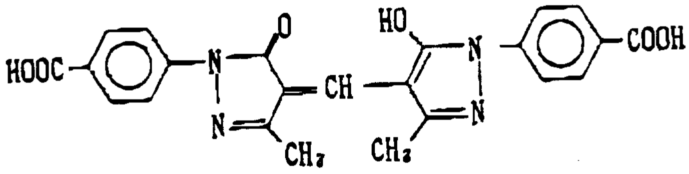

III-2

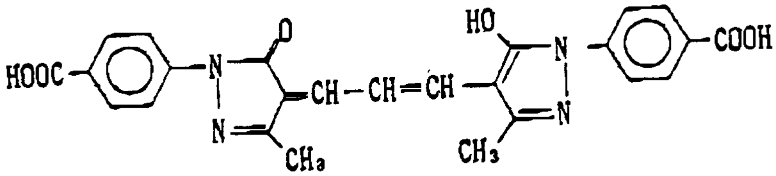

III-3

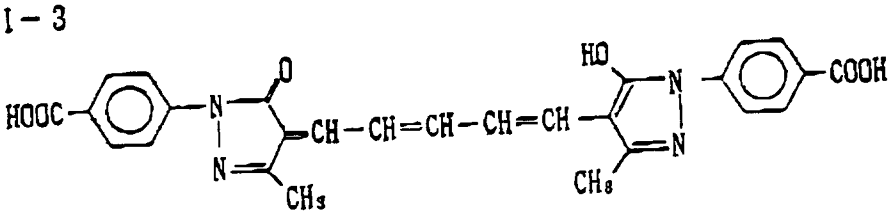

III-4

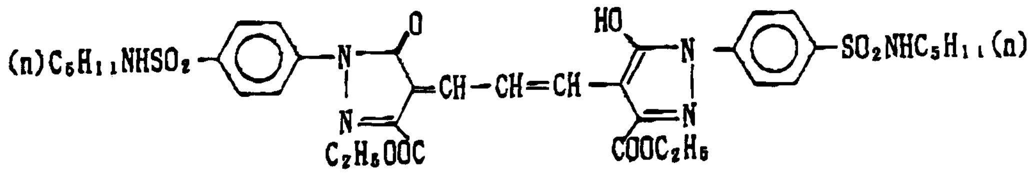

III-5

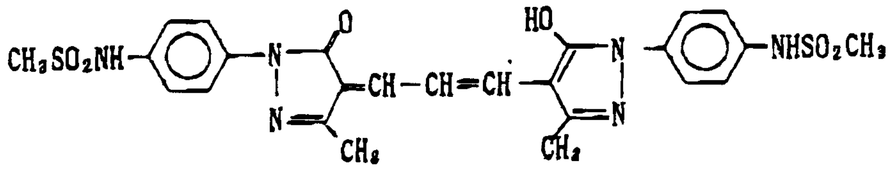

III-6

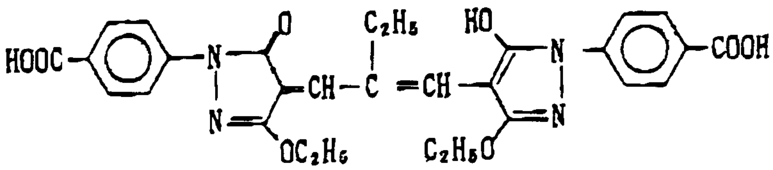

III-7

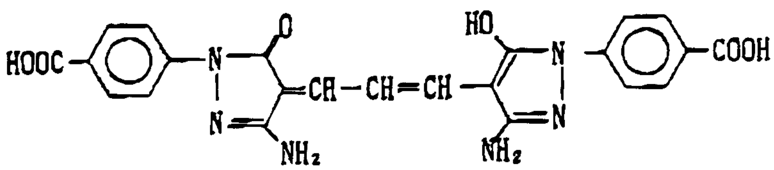

III-8

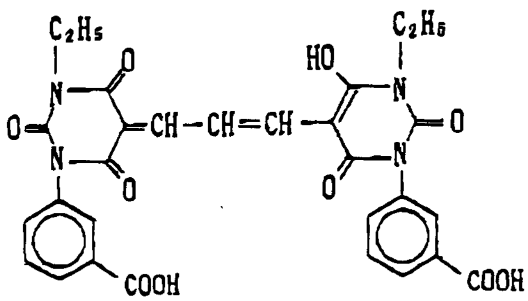

III－9

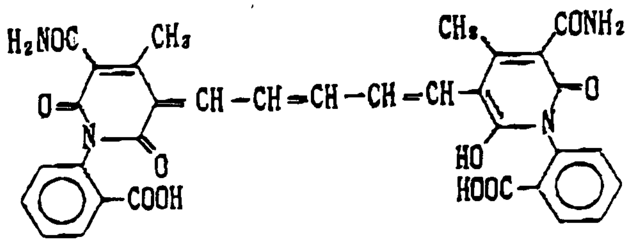

III－１０

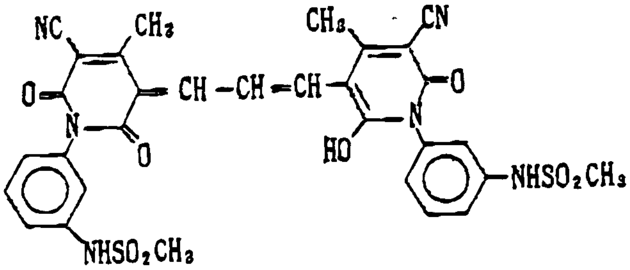

III－１１

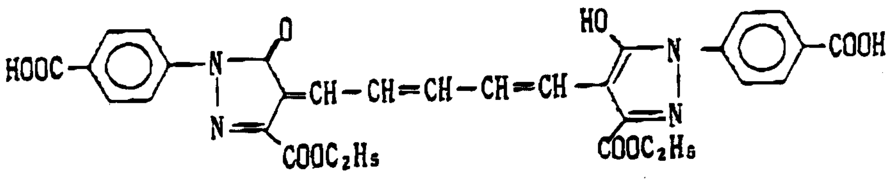

III－１２

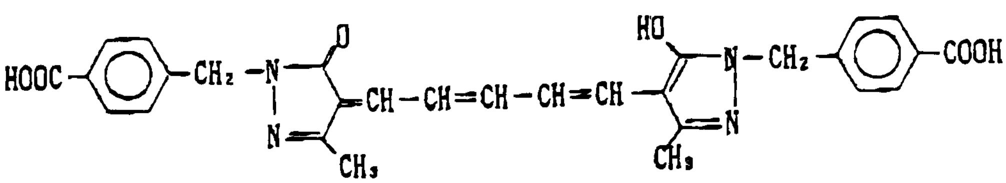

III-13

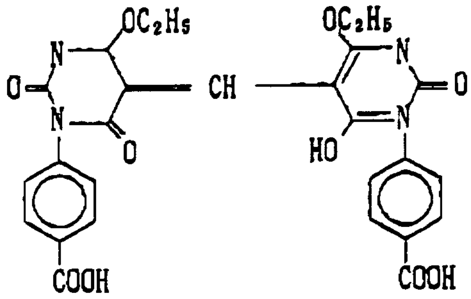

III-14

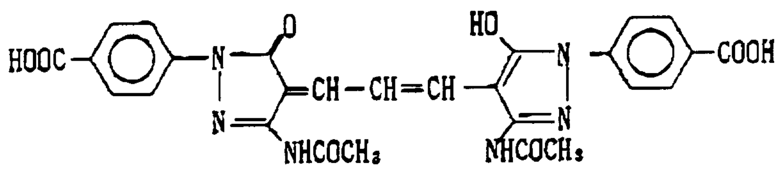

III-15

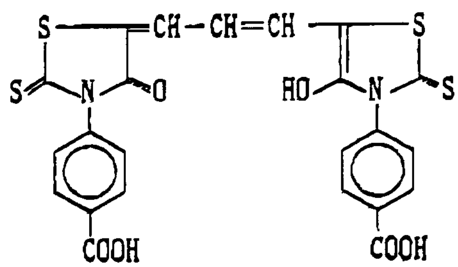

III-16

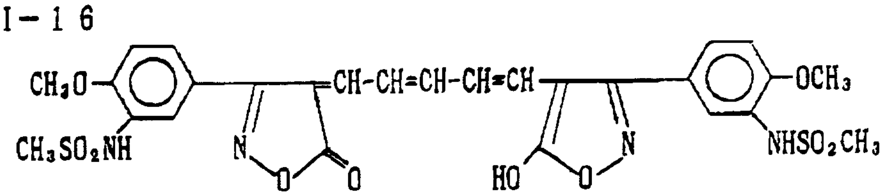

III-17

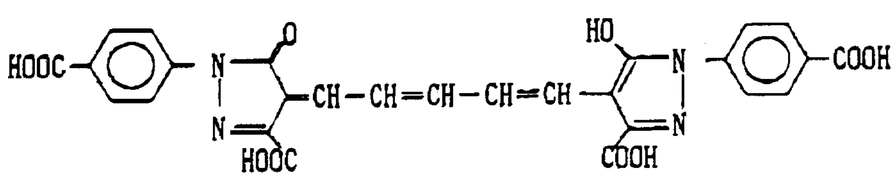

III-18

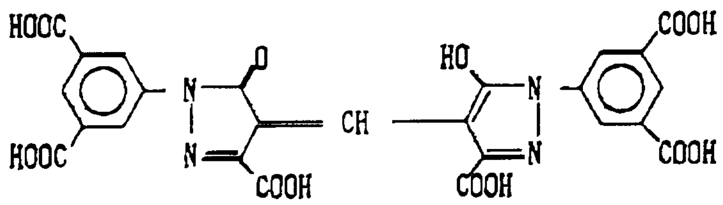

III-19

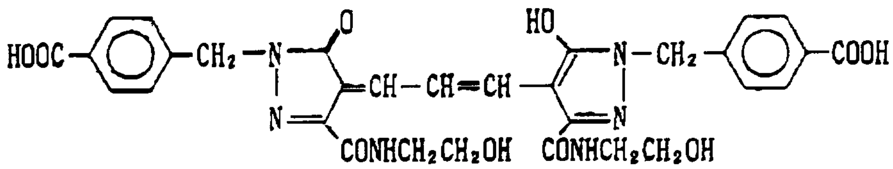

III-20

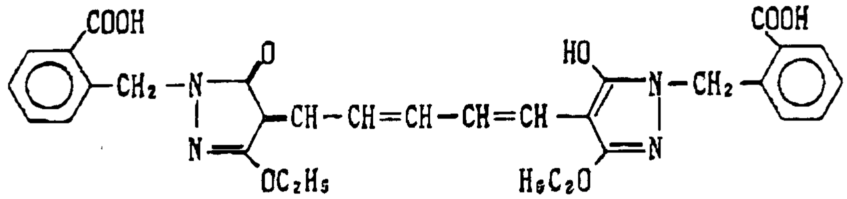

III-21

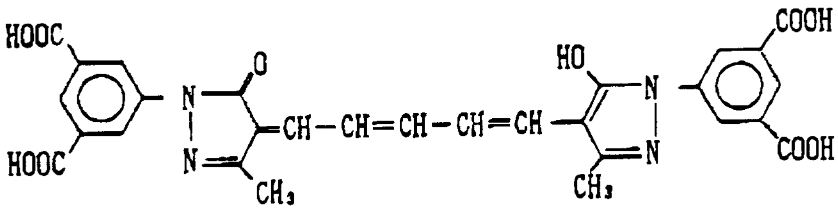

III-22

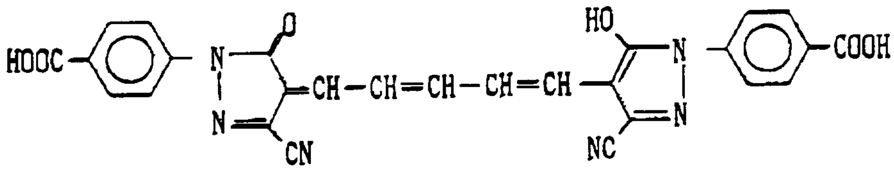

III-23

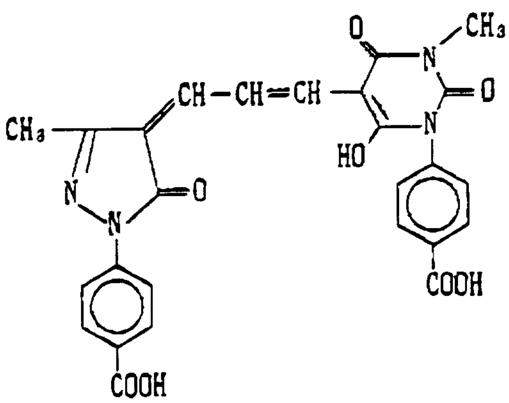

III-24

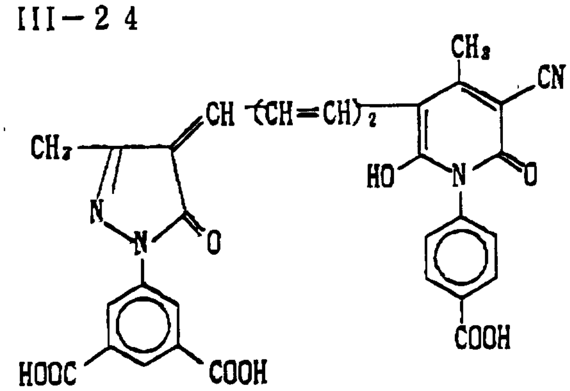

III-25

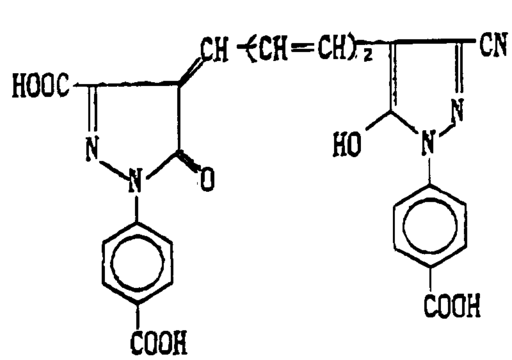

III-26

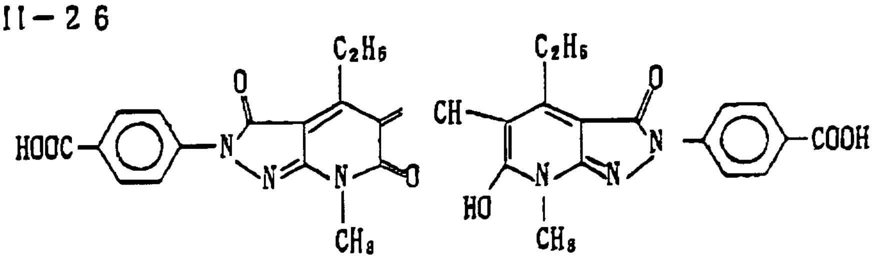

III-27

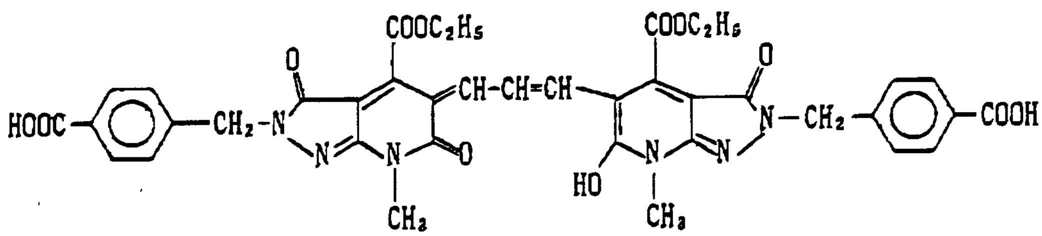

III-28

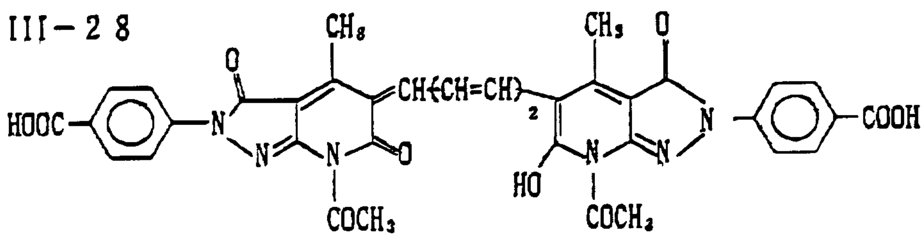

III-29

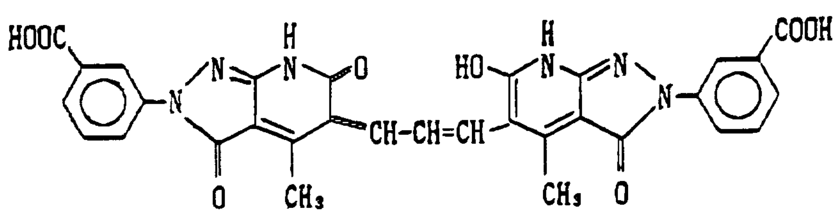

III－3 0

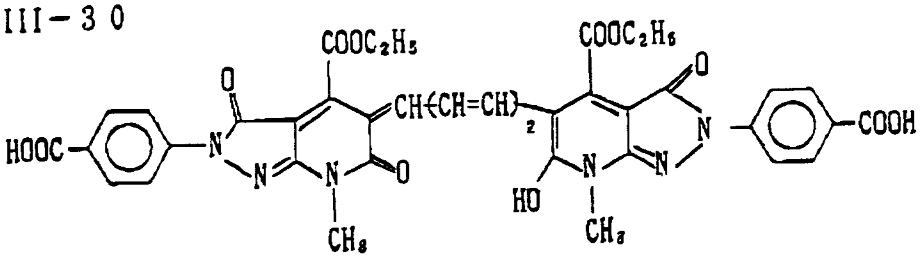

III－3 1

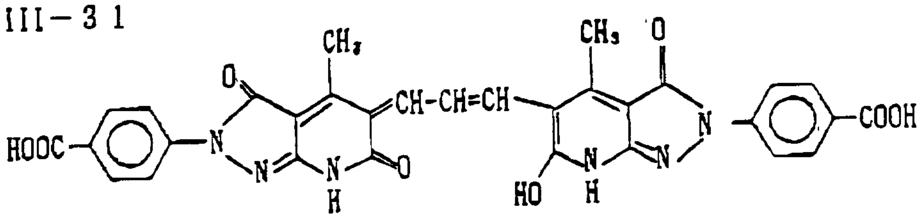

III－3 2

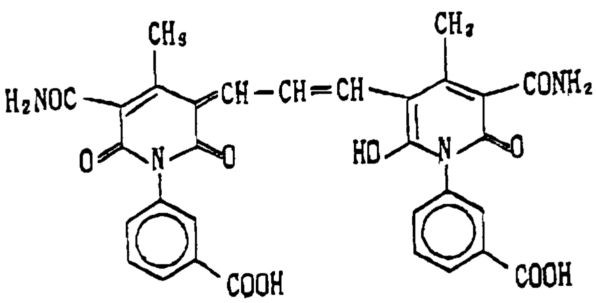

III－3 3

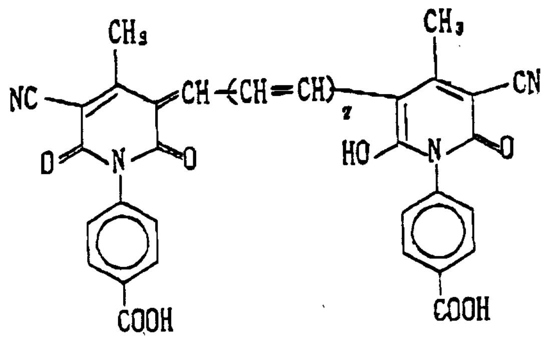

III－３４

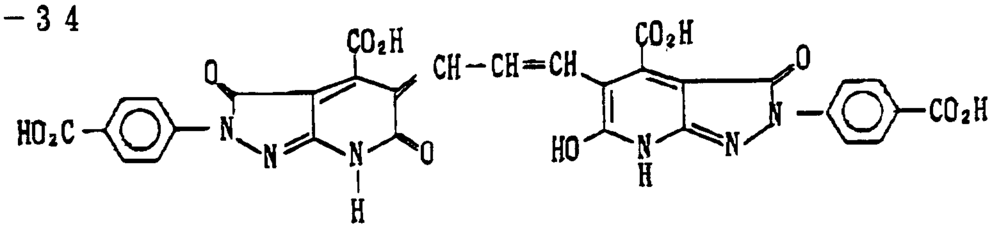

III－３５

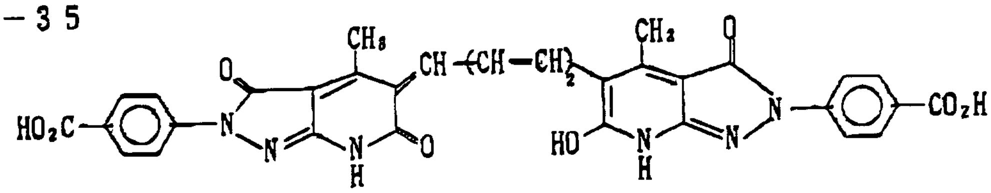

III－３６

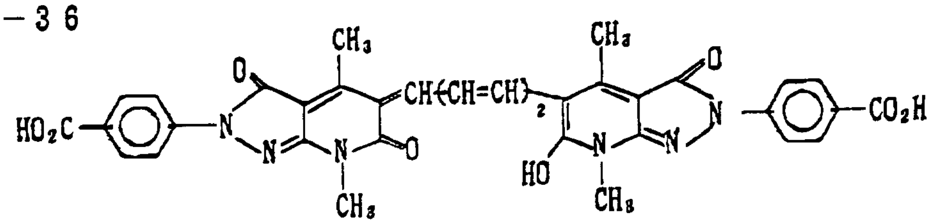

III－３７

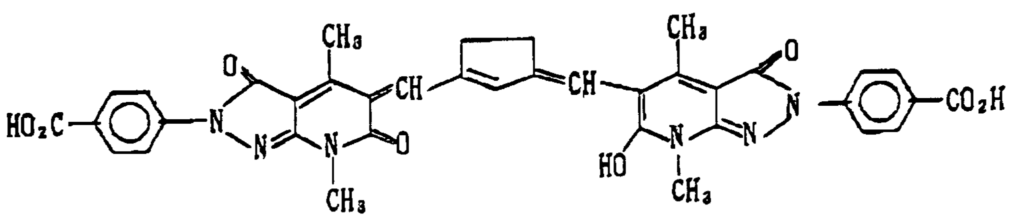

III-38

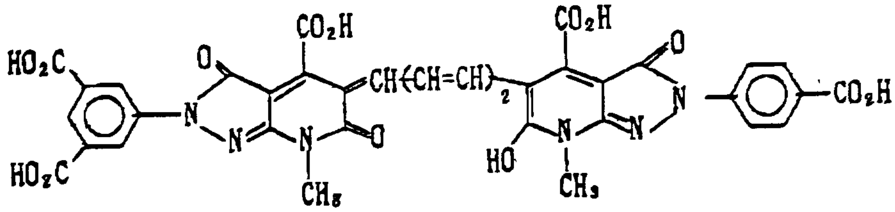

III-39

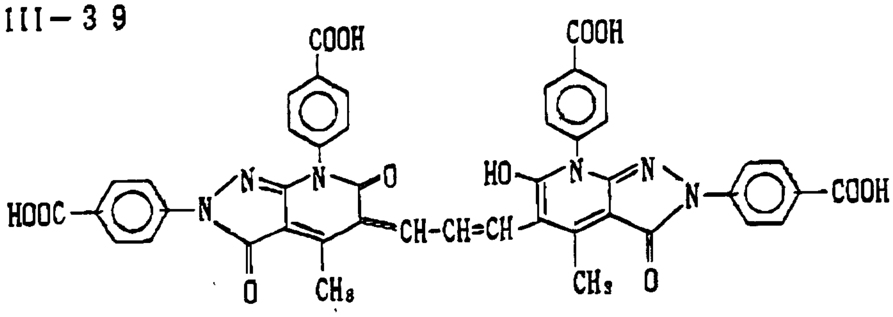

III-40

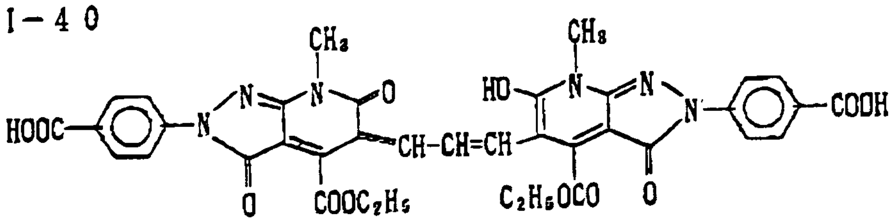

IV-1

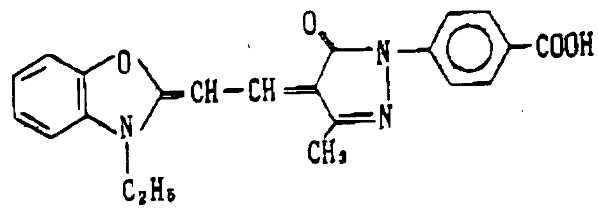

IV-2

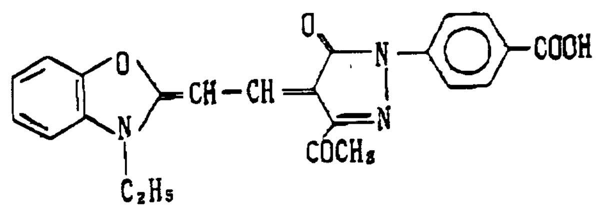

IV-3

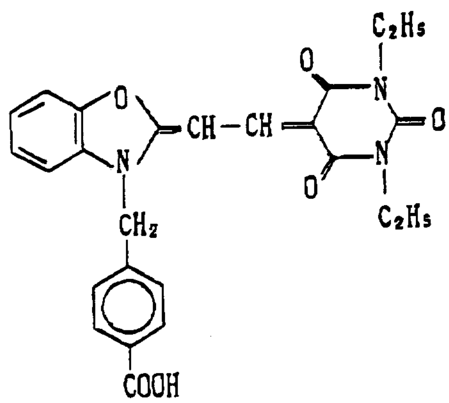

IV- 4

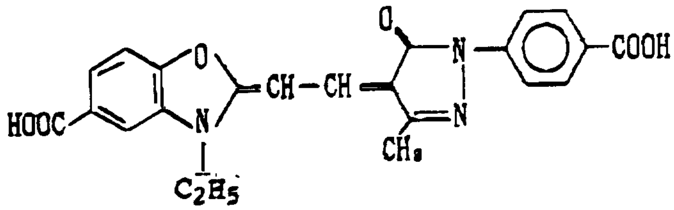

IV- 5

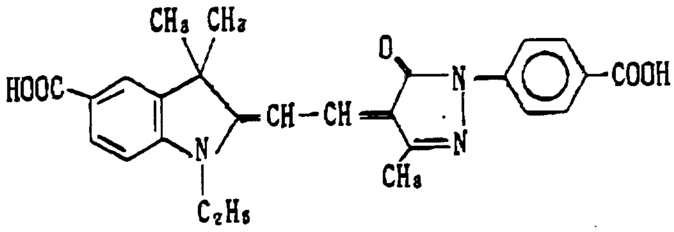

IV- 6

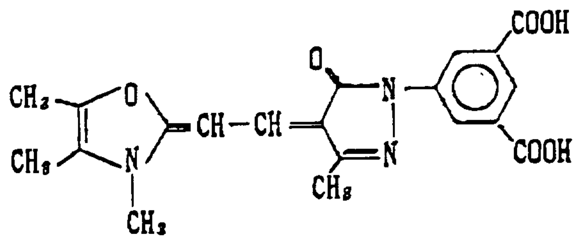

IV- 7

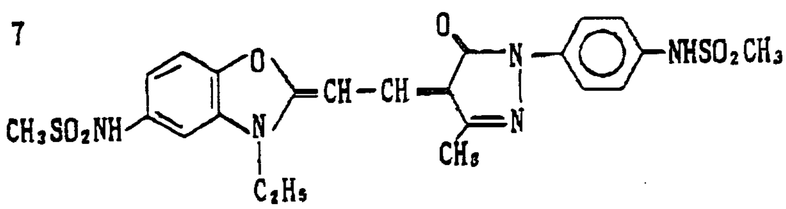

IV－8

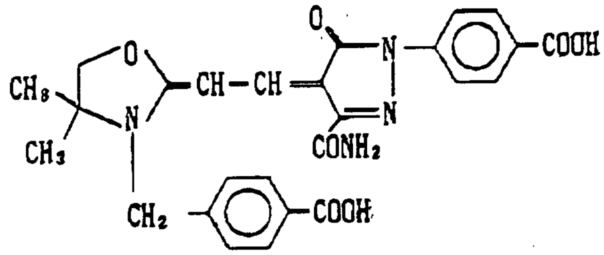

IV－9

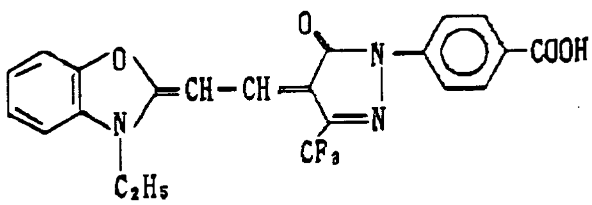

IV－10

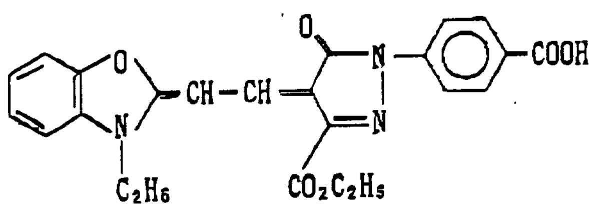

IV－11

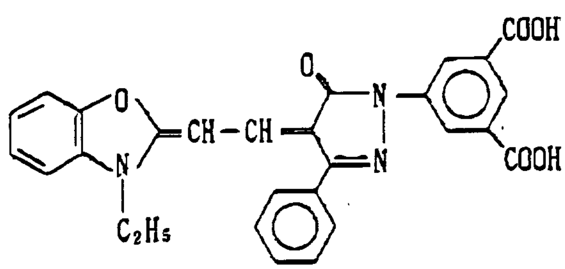

V－1

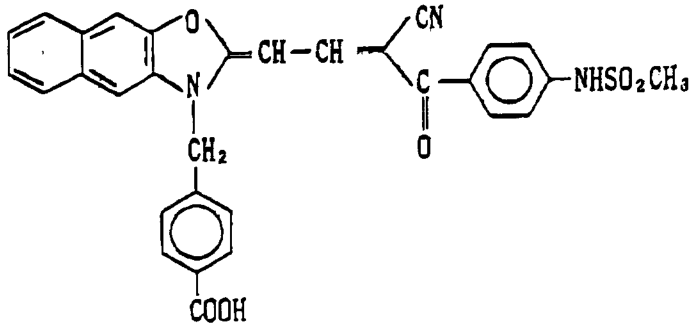

V－2

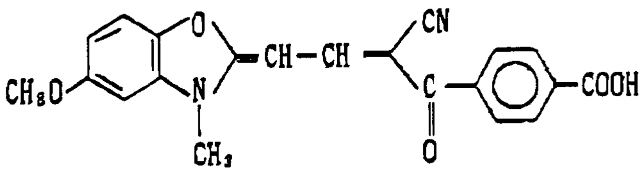

V－3

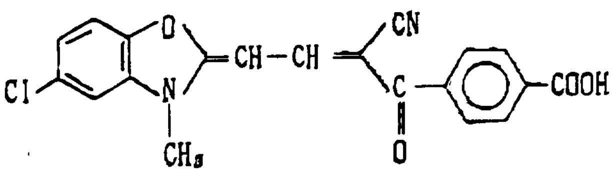

V－4

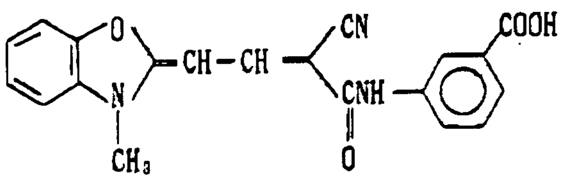

VI－1

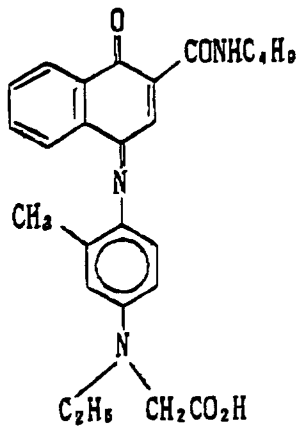

VI－2

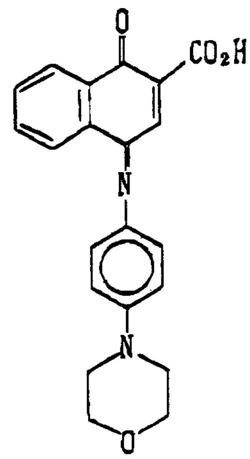

VI－3

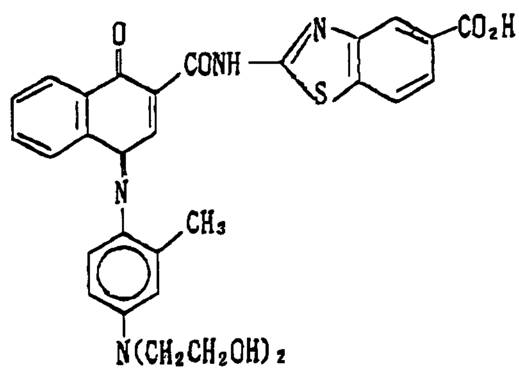

VI－4

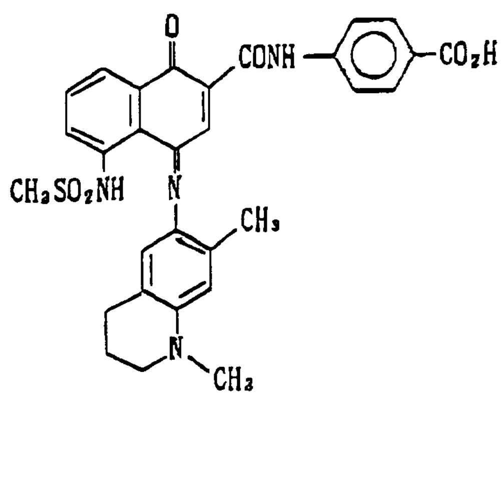

VI-5

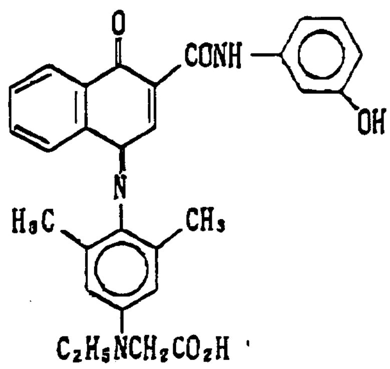

VI-6

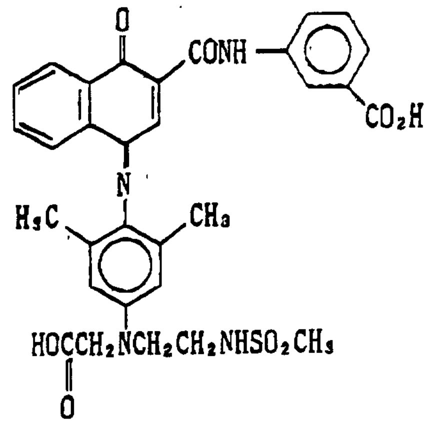

VI-7

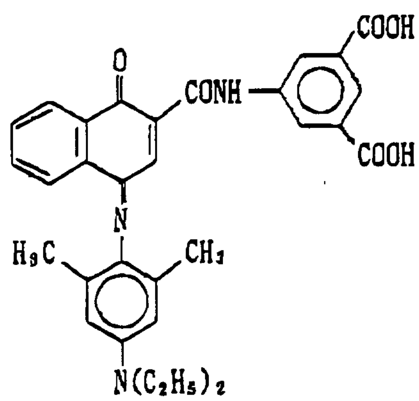

VI-8

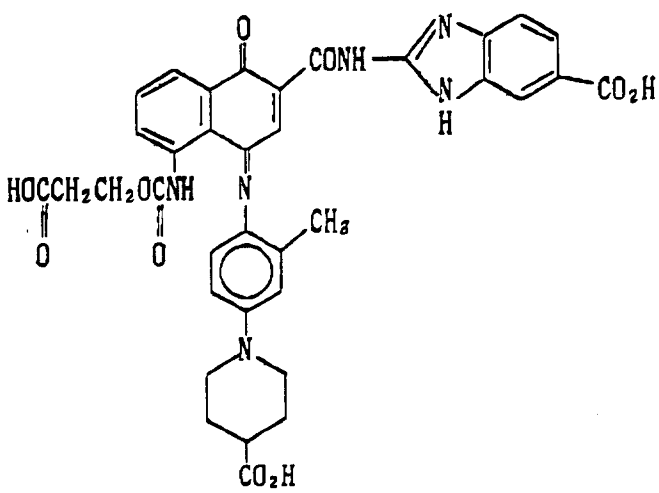

VI－9

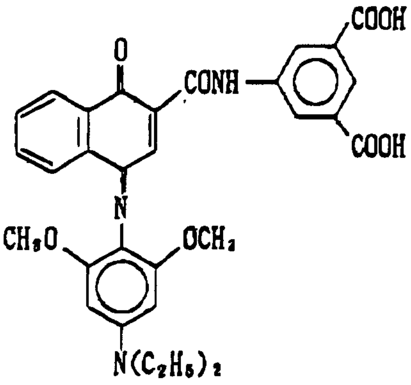

VI－10

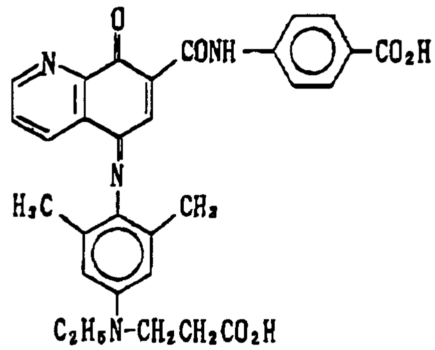

VI－11

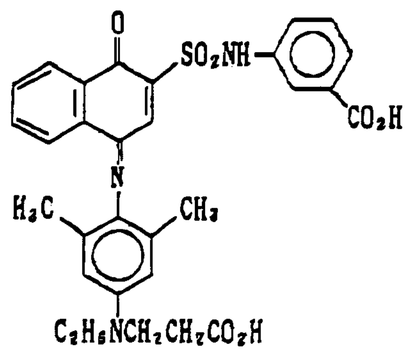

VI－12

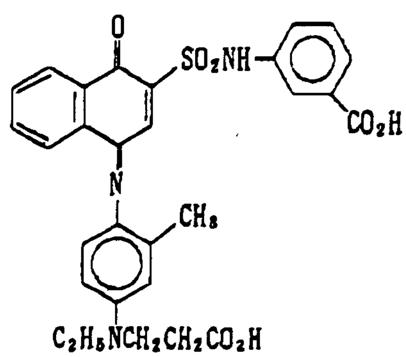

VI－１３

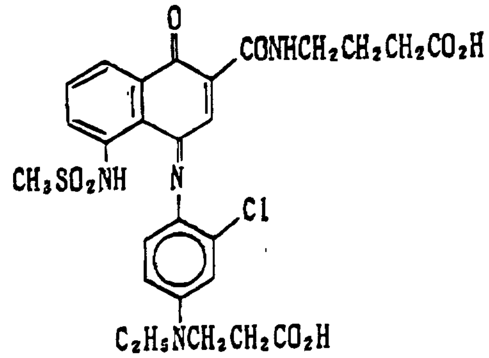

VI－１４

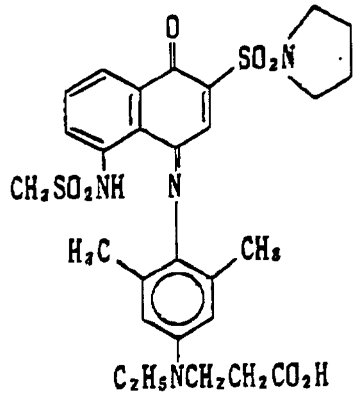

VI－１５

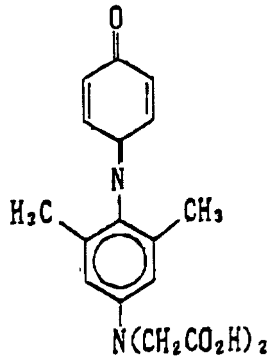

VI－１６

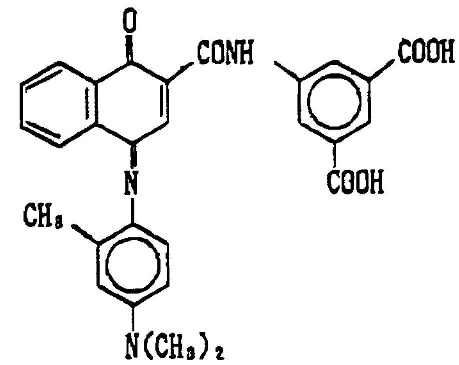

VI－１７

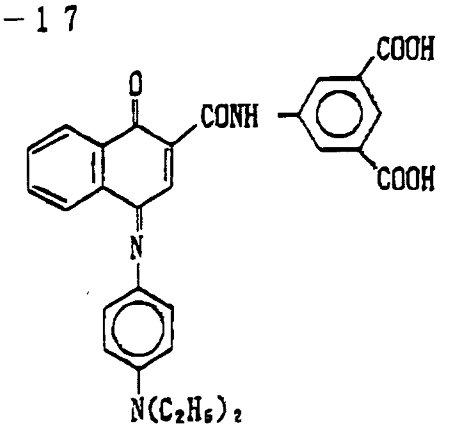

VI－１８

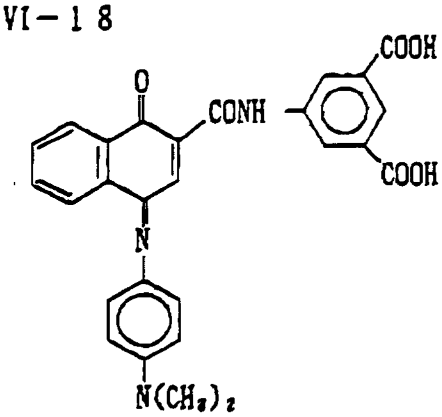

VI－１９

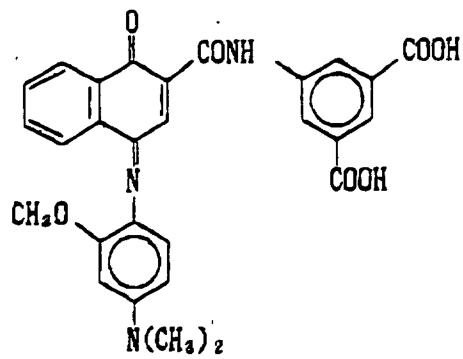

VI－２０

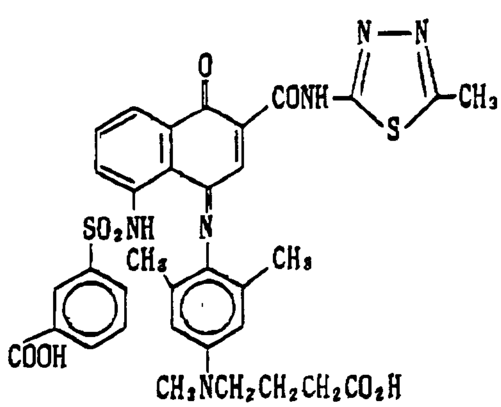

VI－２１

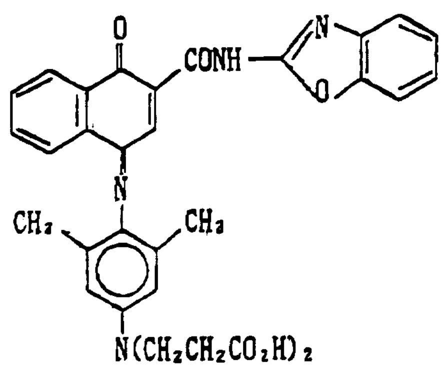

VII-1

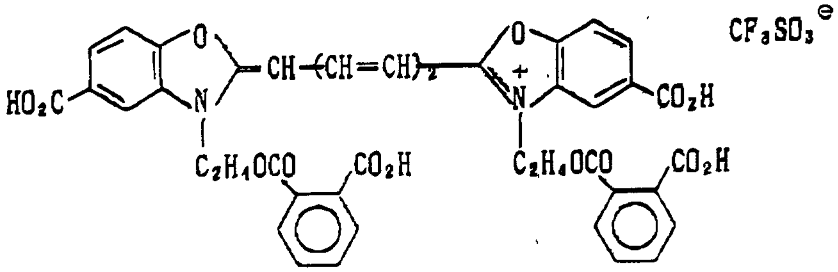

VII-2

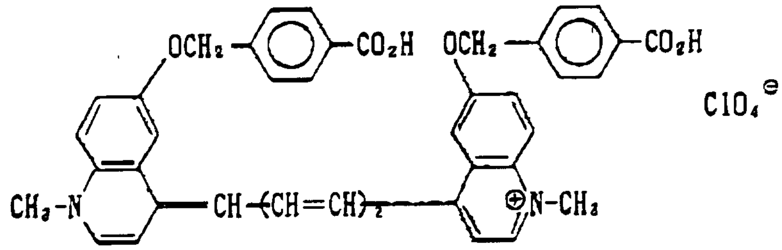

VII-3

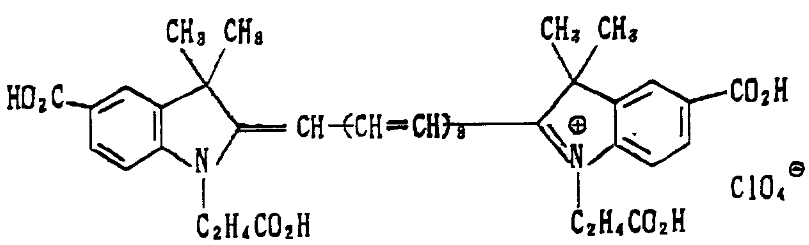

VII-4

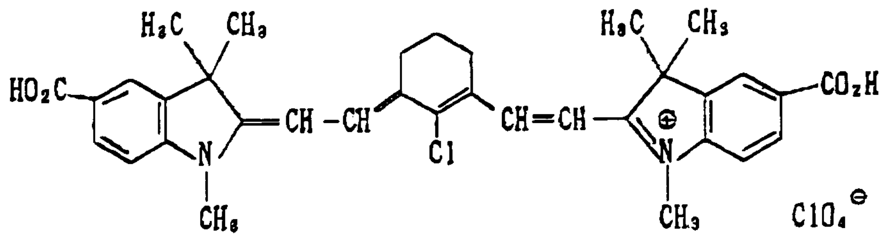

VII-5

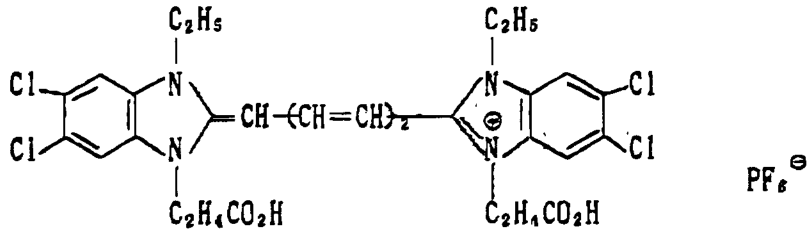

VII-6

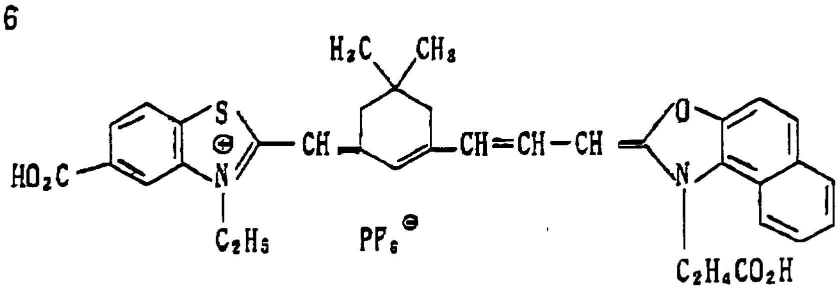

These compounds can be readily synthesized by any of the methods described in WO 88/04794, EP 0274723 A1, 276566, 299435, JP-A 068623/1973, 092716/1977, 155350/1980, 155351/1980, 205934/1986, 173630/1990, and 013937/1991, USP 2,527,583, 3,486,397, 3,746,539, 3,933,798, 4,040,841, and 4,130,429, or a similar method.

We have found that an undercoat layer containing a solid particle dispersion of the dyestuff defined above is preferred to carbon black as an anti-halation layer having no adverse influence on printing properties including run length and ink receptivity.

For positive lithographic printing material, a negative surface latent cage emulsion is used. The silver halide composition of the emulsion is typically selected from silver chloride, silver bromide, and mixed silver halide such as silver chlorobromide, silver chloroiodobromide and silver iodobromide. The preferred silver halides used herein include silver chloro(iodo)bromide, silver (iodo)chloride and silver (iodo)bromide which are free of silver iodide or contain up to 3 mol% of silver iodide, and silver chlorobromide containing up to 20 mol% of bromine.

The silver halide grains preferably have a mean grain size of from 0.1 to 2 μm, more preferably from 0.15 to 1 μm. For spherical or nearly spherical grains, the mean grain size is an average of the diameters of grains and for cubic grains, it is an average based on the projected areas of grains with the side length being the grain size. The grain size distribution may be either narrow or broad although a commonly known

"monodisperse" silver halide emulsion having a narrow grain size distribution that more than 90%, especially more than 95% based on grain number or weight of the entire grains fall within ±40%, are preferably within ±30%, most preferably within ±20% of the mean grain size is preferred for improving graininess and sharpness. To satisfy the designed-for gradation of the lithographic printing material, in emulsion layers having substantially identical color sensitivity, two or more monodisperse silver halide emulsions having different grain sizes or two or more silver halide emulsions containing grains of the same size, but of different sensitivities may be mixed in a single layer or coated as separate layers in an overlapping manner. Alternatively, two or more poly-dispersed silver halide emulsions or a mono-dispersed emulsion and a poly-dispersed emulsion may be mixed or overlapped.

The silver halide grains may have a regular crystal form such as cubic, octahedral, dodecahedral (12-sided) and tetradecahedral (14-sided) forms, an irregular crystal form such as spherical form, and a composite form of these crystal forms. Also plate grains are acceptable, and especially useful are emulsions wherein plate grains having an aspect (length/breadth) ratio of at least 5, especially at least, 8 occupy at least 50% of the overall projected areas of grains. Emulsions containing a mixture of different crystal form grains are also useful.

As used herein, the silver halide emulsion may be prepared in the presence of a silver halide solvent. Examples of the silver halide solvent include organic thioethers as described in USP 3,271,157, 3,531,289, and 3,574,628 and JP-A 001019/1979 and 158917/1979, and thiourea derivatives as described in JP-A 082408/1978, 077737/1980 and 003982/1980. In the preparation of such emulsions, grains may be doped with metals such as Ir, Rh, Ru, Pd, Pt, Pb and Fe during grain formation. The silver halide emulsion used herein may be chemically sensitized by effecting sulfur or selenium sensitization, reducing sensitization or noble metal sensitization alone or in combination within or on silver halide grains.

To the lithographic printing material of the invention there may be added sensitizing dyes (e.g., cyanine dyes and merocyanine dyes) as described in JP-A 052050/1980, pages 45-53 for the purpose of increasing sensitivity. The sensitizing dyes may be used alone or in combination of two or more. A combination of sensitizing dyes is frequently used for supersensitization. Along with the sensitizing dye, a dye which itself is free of spectral sensitizing ability or a substance which does not substantially absorb visible light, but contributes to supersensitization may be contained in the emulsion. Useful sensitizing dyes, dye combinations providing supersensitization and substances contributing to supersensitization are described in the foregoing patents as well as Research Disclosure, Vol. 176, 17643 (December 1978), page 23, items IV-A to J.

It will be understood that the sensitizing dyes or the like may be added at any step of the emulsion preparation process and at any stage after the end of preparation until coating. For example, they may be added at the step of grain formation, physical ripening or chemical ripening.

The sensitizing dye used herein may be selected from orthochromatic sensitizing dyes, panchromatic sensitizing dyes, and infrared sensitizing dyes in accordance with a particular high-illumination intensity light source such as conventional tungsten halide lamps and Ar, He-Ne and semiconductor lasers.

For negative lithographic printing material, a previously unfogged internal latent image type silver halide emulsion is used. It is an emulsion in which silver halide grains are not previously fogged on their surface and a latent image is formed mainly in the grain interior. More particularly, provided that a silver halide emulsion is coated on a transparent support to a predetermined coverage, exposed for a fixed time of 0.01 to 10 seconds, and developed in a developer before the maximun density is measured by conventional photographic densitometry, the emulsion should preferably be such that the maximum density obtained upon development in developer A (internal developer, as defined below) at 20°C for 6 minutes is at least 5 times, preferably at least 10 times higher than the maximum density obtained upon development in developer B (surface developer, as defined below) at 18°C for 5 minutes.

| Internal developer A | |
|---|---|
| Metol | 2 g |
| Sodium sulfite (anhydrous) | 90 g |
| Hydroquinone | 8 g |
| Sodium carbonate monohydrate | 52.5 g |
| KBr | 5 g |
| KI | 0.5 g |
| Water totaling to | 1 liter |

| Surface developer B | |
|---|---|
| Metol | 2.5 g |
| L-ascorbic acid | 10 g |
| $NaBO_2 \cdot 4H_2O$ | 35 g |
| KBr | 1 g |
| Water totaling to | 1 liter |

Illustrative examples of the internal latent image type emulsion include conversion type silver halide emulsions and core/shell type silver halide emulsions as described in UK Patent No. 1,011,062 and US Patent Nos. 2,592,250 and 2,456,943. The core/shell type silver halide emulsions are described in JP-A 032813/1972, 032814/1972, 134721/1977, 156614/1977, 060222/1978, 066218/1978, 066727/1978, 127549/1980, 136641/1982, 070221/1983, 208540/1984, 216136/1984, 107641/1985, 247237/1985, 002148/1986, and 003137/1986, JP-B 18939/1981, 01412/1983, 01415/1983, 06935/1983, and 108528/1983, Japanese Patent Application No. 36424/1986, US Patent Nos. 3,206,313, 3,317,322, 3,761,266, 3,761,276, 3,850,637, 3,923,513, 4,035,185, 4,395,478, and 4,504,570, EP 0017148, and Research Disclosure, RD 16345 (November 1977).

The silver halide composition is typically selected from silver chloride, silver bromide, and mixed silver halide such as silver chlorobromide, silver chloroiodobromide and silver iodobromide. The preferred silver halides used herein include silver chloro(iodo)bromide, silver (iodo)chloride and silver (iodo)bromide which are free of silver iodide or contain up to 3 mol% of silver iodide, and silver chlorobromide containing up to 20 mol% of bromine.

The silver halide grains preferably have a mean grain size of from 0.1 to 2 µm, more preferably from 0.15 to 1 µm. For spherical or nearly spherical grains, the mean grain size is an average of the diameters of grains and for cubic grains, it is an average based on the projected areas of grains with the side length being the grain size. The grain size distribution may be either narrow or broad although a commonly known "monodisperse" silver halide emulsion having a narrow grain size distribution that more than 90%, especially more than 95% based on grain number or weight or the entire grains fall within ±40%, more preferably within ±30%, most preferably within ±20% of the mean grain size is preferred for improving graininess and sharpness. To satisfy the designed-for gradation of the lithographic printing material, in emulsion layers having substantially identical color sensitivity, two or more monodisperse silver halide emulsions having different grain sizes or two or more silver halide emulsions containing grains of the same size, but of different sensitivities may be mixed in a single layer or coated as separate layers in an overlapping manner. Alternatively, two or more poly-dispersed silver halide emulsions or a mono-dispersed emulsion and a poly-dispersed emulsion may be mixed or overlapped.

The silver halide grains may have a regular crystal form such as cubic, octahedral, dodecahedral (12-sided) and tetradecahedral (14-sided) forms, an irregular crystal form such as spherical form, and a composite form of these crystal forms. Also plate grains are acceptable, and especially useful are emulsions wherein plate grains having an aspect (length/breadth) ratio of at least 5, especially at least 8 occupy at least 50% of the overall projected areas of grains. Emulsions containing a mixture of different crystal form grains are also useful.

As used herein, the silver halide emulsion may be prepared in the presence of a silver halide solvent. Examples of the silver halide solvent include organic thioethers as described in USP 3,271,157, 3,531,289, and 3,574,628 and JP-A 001019/1979 and 158917/1979, and thiourea derivatives as described in JP-A 082408/1978, 077737/1980 and 003982/1980. In the preparation of such emulsions, grains may be doped with metals such as Ir, Rh, Ru, Pd, Pt, Pb and Fe during grain formation. The silver halide emulsion used herein may be chemically sensitized by effecting sulfur or selenium sensitization, reducing sensitization or noble metal sensitization alone or in combination within or on silver halide grains.

To the lithographic printing material of the invention there may be added sensitizing dyes (e.g., cyanine dyes and merocyanine dyes) as described in JP-A 052050/1980, pages 45-53 for the purpose of increasing sensitivity. The sensitizing dyes may be used alone or in combination of two or more. A combination of sensitizing dyes is frequently used for supersensitization. Along with the sensitizing dye, a dye which itself is free of spectral sensitizing ability or a substance which does not substantially absorb visible light, but contributes to supersensitization may be contained in the emulsion. Useful sensitizing dyes, dye combinations providing supersensitization and substances contributing to supersensitization are described in the foregoing patents as well as Research Disclosure, Vol. 176, 17643 (December 1978), page 23, items IV-A to J.

It will be understood that the sensitizing dyes or the like may be added at any step of the emulsion preparation process and at any stage after the end of preparation until coating. For example, they may be added at the step of grain formation, physical ripening or chemical ripening.

The sensitizing dye used herein may be selected from orthochromatic sensitizing dyes, panchromatic sensitizing dyes, and infrared sensitizing dyes in accordance with a particular high-illumination intensity light source such as conventional tungsten halide lamps and Ar, He-Ne and semiconductor lasers.

For negative lithographic printing material, a pre-fogged silver halide emulsion is also used. The emulsion preferably contains silver halide grains having a size of 0.40 to 0.10 μm. Larger grain sizes would exacerbate graininess and reversal, resulting in high Dmin. Smaller grain sizes would result in low Dmax, obstructed reversal and high Dmin. This tendency is emphasized when red or infrared sensitive desensitizing dyes are used. Therefore, an optimum grain size should be selected for those photosensitive materials intended for such a particular photosensitive region.

Also, the grain size is important for brief high-illumination intensity exposure such as exposure for less than $10^{-2}$ sec. In the case of low-illumination intensity exposure, Dmax and Dmin depend little on the grain size, and high development efficiency, high Dmax and low Dmin are available at any grain size. In the case of high-illumination intensity exposure, however, an optimum range of grain size should be used.

Grains are formed and washed with water before they are fogged with gold compounds, for example, chloroauric acid and derivatives thereof. The amount of gold compound used herein is preferably 0.05 to 0.0005 millimoles per mole of silver although the amount varies with the grain size and halogen composition. Dmin would increase with larger amounts of the gold compound while Dmax would not well develop with smaller amounts of the gold compound.

The pre-fogged silver halide used herein should preferably have a halogen composition selected from silver bromide and silver chlorobromide, silver chloroiodobromide and silver iodobromide having a Br content of at least 5 mol%. Silver chloride results in poor reversal.

The pre-fogged silver halide emulsion used herein may be prepared by any of acidic, neutral, and ammoniacal methods.

Preferably the pre-fogged silver halide grains used herein have a mean grain diameter of 0.4 to 0.1 μm. The grain size distribution may be either narrow or broad, preferably narrow. Preferred is a commonly known "monodisperse" silver halide emulsion having a narrow grain size distribution that more than 90%, especially more than 95% based on grain number or weight of the entire grains fall within ±40%, more preferably within ±20% of the mean grain size. The silver halide grains may have a single crystal habit or a mixture of crystal habits, with the single crystal habit being preferred.

In addition to the above-mentioned components, the prefogged silver halide used herein may contain an inorganic desensitizing agent (that is, a noble metal atom contained in silver halide grains) and an organic desensitizing agent which adsorbs to the silver halide surface alone or in combination. The inorganic desensitizing agent may be incorporated into silver halide grains by adding an aqueous solution of a water-soluble noble metal compound during preparation of silver halide grains in an amount of $10^{-7}$ to $10^{-2}$ mol, especially $10^{-5}$ to $10^{-3}$ mol per mol of silver halide. Exemplary noble metal compounds are chlorides of metals of Group VIII in the Periodic Table such as iridium, rhodium and ruthenium.

For providing fog to silver halide, a conventional well-known technique may be used after water-soluble salts resulting from sedimentation of silver halide are removed. Fogging may be effected by foggants (or reducing agents) alone or combinations of a foggant with a gold compound or another useful metal compound which is electrically are positive than silver.

Typical of the foggants useful to prepare the desired emulsion are formalin, hydrazines, polyamines (e.g., triethylene tetramine and tetraethylene pentamine), thiourea dioxide, tetra(hydroxymethyl)-phosphonium chloride, aminoborine, hydrogenated boron compounds, stannous chloride, and tin (II) chloride. The foggant is generally used in an amount of $1.0 \times 10^{-6}$ to $1.0 \times 10^{-1}$ mol per mol of silver halide.

Typical examples of the gold compound include chloroauric acid, sodium chloroaurate, gold sulfide, and gold selenide. They are preferably used in an amount of $1.0 \times 10^{-8}$ to $1.0 \times 10^{-4}$ mol per mol of silver halide. Examples of the metal compound which is electrically more positive than silver include soluble salts of gold, rhodium, platinum, palladium, and iridium, for example, potassium chloroaurate, chloroauric acid, ammonium palladium chloride, and sodium iridium chloride.

For the pre-fogged direct positive silver halide emulsion used herein, the extent of fogging may vary over a wide range. As is well known to the skilled artisan in the art, the extent of fogging is correlated to the silver halide composition and grain size of a silver halide emulsion, the type and concentration of a foggant used, the pH and pAg of the emulsion at the time of fogging, temperature and time.

Any of commonly used photographic additives may be contained in the photographic silver halide photosensitive material used as the direct positive lithographic printing material of the invention. Exemplary

stabilizers include triazoles, azaindenes, quaternary benzothiazolium compounds, mercapto compounds and water-soluble inorganic salts of cadmium, cobalt, nickel, manganese, gold, thallium, and zinc. Exemplary hardeners include aldehydes such as formalin, glyoxal, and mucochloric acid, S-triazines, epoxy compounds, aziridines, and vinylsulfonic acid. Exemplary coating aids include saponin, sodium polyalkylene sulfonates, lauryl or oleyl monoether of polyethylene glycol, amylated alkyltaurines, and fluorinated compounds. Exemplary sensitizers include polyalkylene oxides and derivatives thereof. Also color couplers may be contained. Additionally, brighteners, UV absorbers, preservatives, matte agents, anti-static agents or the like may be contained if necessary.

Desensitizing dyes may be used in the pre-fogged silver halide emulsion. They are described in Japanese Patent Application Nos. 205737/1992, 212670/1992, 203929/1992, 212671/1992, 214110/1992, 220906/1992, and 232696/1992.

In the emulsion layer or another hydrophilic colloidal layer, water-soluble dyes may be contained as the filter dye or for anti-irradiation or various other purposes. Preferred filter dyes include dyes for further reducing photographic sensitivity and dyes having substantial light absorption in the range of 330 to 800 nm for increasing safety against safe light. In accordance with their purpose, these dyes are preferably added to a silver halide emulsion layer or they are added above a silver halide emulsion layer, that is, to a non-photosensitive hydrophilic colloid layer disposed remote from the silver halide emulsion with respect to the support together with a mordant in a fixed manner. They are generally added in amounts of $10^{-2}$ g/m$^2$ to 1 g/m$^2$, preferably 50 mg/m$^2$ to 500 mg/m$^2$ depending on the molar extinction coefficient thereof. Exemplary dyes are described in JP-A 064039/1988.

In the practice of the invention, various other compounds can be added to lithographic printing material for the purposes of preventing fogging and stabilizing photographic performance during preparation, storage or processing of the lithographic printing material. Useful additives are antifoggants and stabilizers including azoles, for example, benzothiazolium salts, nitroindazoles, chlorobenzimidazoles, bromobenzimidazoles, mercaptothiazoles, mercaptobenzothiazoles, mercaptothiadiazoles, aminotriazoles, benzothiazoles, and nitrobenzotriazoles; mercaptopyrimidines; mercaptotriazines; thioketo compounds such as oxazolinethion; azaindenes such as triazaindenes, tetraazaindenes (e.g., 4-hydroxy substituted-1,3,3a,7-tetraazaindenes), and pentaazaindenes; benzenethiosulfonic acid, benzenesulfinic acid, and benzenesulfonic amide, which are known as antifoggants or stabilizers.

The lithographic printing material of the invention includes an emulsion layer to which may be added an agent for providing increased sensitivity, increased contrast, or accelerated developent. Such agents include polyalkylene oxides or ethers, esters, amines and other derivatives thereof, thioether compounds, thiomorpholine compounds, quaternary ammonium salt compounds, urethane derivatives, urea derivatives, imidazole derivatives, and developing agents such as dihydroxybenzenes and 3-pyrazolidones. Preferred among others are dihydroxybenzenes such as hydroquinone, 2-methylhydroquinone and catechol and 3-pyrazolidones such as 1-phenyl-3-pyrazolidone and 1-phenyl-4-methyl-4-hydroxymethyl-3-pyrazolidone. They are generally used in a coverage of less than 5 g/m$^2$. Preferably the dihydroxybenzenes are used in a coverage of 0.01 to 2.5 g/m$^2$ while the pyrazolidones are used in a coverage of 0.01 to 0.5 g/m$^2$.

The lithographic printing material of the present invention is generally in the form of a silver salt offset printing material of a basic layer structure including an anti-halation layer as a undercoat layer on a support, a photo-sensitive silver halide emulsion layer on the undercoat, and a physical development nucleus layer on the emulsion layer. An intermediate layer may be interposed between any two adjacent layers. Preferably, the printing material of the invention has a physical development nucleus layer disposed directly on a photosensitive silver halide emulsion layer.

In the practice of the invention, carbon black dyes or pigments may be additionally contained in the undercoat layer insofar as the benefits of the invention are not lost. Fine powder having a size of 1 to 10 $\mu$m such as silica may also be added.

Included in the silver halide emulsion used herein is a hydrophilic binder which is generally gelatin. Also advantageously gelatin may be modified by partially or entirely replacing by synthetic polymers such as polyvinyl alcohol, poly-N-vinyl pyrrolidone, polyacrylic acid copolymers, and methyl vinyl ether/maleic anhydride copolymers or cellulose derivatives, gelatin derivatives or the like. Various other compounds can be added to the emulsion for the purposes of preventing fog during development and providing stabilization during preparation or storage as previously described.

In addition to the above-mentioned compounds, there may be used various other additives such as hardeners and surfactants. Exemplary compounds are described in Product Licensing Index, vol. 92, No. 9232, pages 107-110, I-XIII, XVI-XVII and XXIII (December 1971).

Also included in the printing material is a physical development nucleus layer. Physical development nuclei may be provided by reducing water-soluble salts of noble metals such as gold, silver, platinum and

palladium or heavy metals such as zinc, lead, cadmium, nickel, cobalt, iron, chromium, tin, antimony and bismuth to form metal colloids, or by mixing water-soluble salts of such metals, for example, nitrates, acetates, borates, chlorides and hydroxides with water-soluble sulfides such as sodium sulfide.

A hydrophilic binder is used in the physical development nucleus layer. Useful binders are the same hydrophilic polymers as previously described for the photosensitive silver halide emulsion layer, with gelatin, polyvinyl alcohol or methyl vinyl ether/maleic anhydride copolymers or mixtures thereof being preferred. The amount of the hydrophilic binder used ranges from 30% to 100% based on the weight of the physical development nuclei although it varies with a particular type of noble metal or binder.

Preferably the physical development nucleus layer is coated directly on the photosensitive silver halide emulsion layer.

The support for the offset printing material of the invention includes all types of support commonly used in the art, for example, nitrate film, cellulose acetate film, cellulose acetate butyrate film, polystyrene film, polyethylene phthalate film, polycarbonate film, and laminates thereof, as well as paper. Also useful are baryta and paper coated or laminated with α-olefin polymers, especially polymers of α-olefins having 2 to 10 carbon atoms such as polyethylene, polypropylene, and ethylene-butylene copolymers. The supports may be modified by the surface roughening method for providing enhanced bond to other polymers as described in JP-B 19068/1972 or the surface roughening method of JP-B 135840/1981. Another useful support is paper laminated with metal foil such as aluminum foil for minimizing plate elongation.

Colloidal silica may be used in a coating applied to the polyolefin surface for the purposes of improving adhesion to the polyolefin coated surface or improving printability. In this regard, reference is made to US Patent No. 3,161,519.

To enhance the bonding force between the support and a coating, the support on the surface may be pretreated by corona discharge treatment, ultraviolet exposure or flame treatment. With respect to the corona discharge treatment, reference is made to US Patent No. 2,018,189.

Hardening of the silver halide emulsion and/or other layers can be achieved by conventional techniques. Useful hardeners include aldehydes such as formaldehyde and glutaraldehyde; ketones such as diacetyl and cyclopentanedione; bis(2-chloroethylurea), 2-hydroxy-4,6-dichloro-1,3,5-triazine; compounds having reactive halogen as described in USP 3,288,775 and 2,732,303 and UKP 974,723 and 1,167,207; divinyl sulfone, 5-acetyl-1,3-diacryloylhexahydro-1,3,5-triazine; compounds having reactive olefin as described in USP 3,635,718, 3,232,763, 3,490,911 and 3,642,486 and UKP 994,869; N-hydroxymethylphthalimide; N-methylol compounds as described in USP 2,732,316 and 2,586,168; isocyanates as described in USP 3,103,437; aziridines as described in USP 3,017,280 and 2,983,611; acid derivatives as described in USP 2,725,294 and 2,725,295; carbodiimides as described in USP 3,100,704; epoxy compounds as described in USP 3,091,537; isooxazoles as described in USP 3,321,313 and 3,543,292; halogenocarboxyaldehydes such as mucochloric acid; and dioxane derivatives such as dihydroxydioxane and dichlorodioxane; as well as inorganic hardeners such as chromium alum and zirconium sulfate. Instead of the foregoing compounds, there may be used precursors, for example, alkali metal bisulfite aldehyde adducts, hydantoin methylol,derivatives, and primary aliphatic nitroalcohols.

If desired, well-knob surfactants may be added alone or in admixture to any of the layers of the offset printing material. The surfactants may be used as coating aids and as the case may be, used for other purposes, for example, emulsifying dispersion, development acceleration, improvement of photographic properties, electric charge row adjustment, and antistatic purposes.

Included in the surfactant are natural products such as saponin; anionic or nonionic surfactants such as alkylene oxide, glycerines and glycidols; cationic surfactants such as higher alkyl amines, quaternary ammonium salts, pyridine and other heterocyclics, phosphonium and sulfonium; anionic surfactants having an acidic group such as carboxylic acids, sulfonic acids, phosphoric acids, sulfates, and phosphates; and ampholytic surfactants such as amino acids, aminosulfonic acids, and sulfates and phosphates of amino-alcohols.

Examples of the surfactant used herein are described in USP 2,271,623, 2,240,472, 2,288,226, 2,739,891, 3,068,101, 3,158,484, 3,201,253, 3,210,191, 3,294,540, 3,415,649, 3,441,413, 3,442,654, 3,475,774, and 3,545,574, UKP 1,077,317 and 1,198,450, Oda Ryohei et al., "Kaimen-Kasseizai No Gosei To Sono Oyo (Synthesis of Surfactants and their Application)", Maki-Shoten, 1964, A.W. Perry, "Surface Active Agent", Interscience Publication Inc., 1958, and J.P. Sisley, "Encyclopedia of Active Agent", Vol. 2, Chemical Publish Co., 1964.

As previously described, filter dyes or anti-irradiation dyes may be contained in the offset printing material of the invention. Exemplary dyes are described in USP 2,274,782, 2,527,583, 2,956,879, 3,177,078 and 3,252,921 and JP-B 22069/1964. These dyes may be mordanted by the method described in USP 3,282,699, if desired. The anti-halation layer can be a colored layer containing a pigment such as lamp

black, carbon black, fest black, ultramarine, Malachite Green, and Crystal Violet.

Any of well-known coating techniques may be used to coat layers on the support for constituting the offset printing material of the invention. Exemplary techniques include dipping, air knife, and extrusion doctor techniques, with the bead coating technique described in USP 2,761,791 being most preferred.

The offset printing material of the invention may include a layer having a silver halide developing agent incorporated therein. In this case, development after exposure can be activation treatment with an alkaline aqueous solution.

The developing agent may be contained in a silver halide emulsion layer, an anti-halation layer or a layer adjacent thereto although it is most preferably contained in the anti-halation layer. The alkaline aqueous solution used for development may also contain a developing agent.

Exemplary developing agents are polyhydroxybenzenes, 3-pyrazolidone compounds, and aminophenols. Examples of the polyhydroxybenzene include hydroquinone, catechol, chlorohydroquinone, pyrogallol, bromohydroquinone, isopropylhydroquinone, toluhydroquinone, methylhydroquinone, 2,3-dichlorohydroquinone, 2,5-dimethylhydroquinone, 2,3-dibromohydroquinone, 1,4-dihydroxy-2-acetophenone, 4-phenylcatechol, 4-t-butylcatechol, 4-n-butylpyrogallol, 4,5-dibromocatechol, 2,5-diethylhydroquinone, 2,5-benzoylaminohydroquinone, 4-benzyloxycatechol, and 4-n-butoxycatechol. Especially preferred are hydroquinone and methylhydroquinones.

Examples of the 3-pyrazolidone compound include 1-phenyl-3-pyrazolidone, 1-p-tolyl-3-pyrazolidone, 1-phenyl-4-methyl-3-pyrazolidone, 1-phenyl-4,4-dimethyl-3-pyrazolidone, 1-p-chlorophenyl-3-pyrazolidone, 1-p-methoxyphenyl-3-pyrazolidone, 1-phenyl-2-acetyl-3-pyrazolidone, 1-phenyl-5,5-dimethyl-3-pyrazolidone, 1-o-chlorophenyl-4-methyl-4-ethyl-3-pyrazolidone, 1-m-acetamidophenyl-4,4-diethyl-3-pyrazolidone, 1,5-diphenyl-3-pyrazolidone, 1-(m-tolyl)-5-phenyl-3-pyrazolidone, 4,4-dihydroxymethyl-1-phenyl-3-pyrazolidone, 4,4-dihydroxymethyl-1-tolyl-3-pyrazolidone, 4-hydroxymethyl-4-methyl-1-phenyl-3-pyrazolidone, and 4-hydroxymethyl-4-methyl-1-(p-chlorophenyl)-3-pyrazolidone.

Examples of the aminophenol include p-(methylamino)phenol, p-aminophenol, 2,4-diaminophenol, p-(benzylamino)phenol, 2-methyl-4-aminophenol, and 2-hydroxymethyl-4-aminophenol.

These developing agents may be used alone or in combination. Combinations of polyhydroxybenzenes with 3-pyrazolidones are especially preferred. The developing agent is preferably used in an amount of 0.001 to 1 gram per square meter of the layer to which it is added, especially in an amount of 0.01 to 3 grams per gram of silver halide when it is added to the silver halide emulsion layer.

If desired, a compound, known as a complexing agent, which tends to form a soluble silver complex with silver halide in unexposed areas may be contained in any layer for advantageously accelerating physical development. The complexing agents include thiosulfates, thiocyanates, amine thiosulfates as described in USP 3,169,962, cyclic imides as described in USP 2,857,276, and mercapto compounds as described in JP-B 11957/1971.

The developing agent may be added to a coating solution by dissolving it in water or a hydrophilic solvent such as methanol or by dissolving it in a high or low-boiling organic solvent, The high-boiling organic solvents are those having a boiling point of higher than about 180 °C, for example, alkyl phthalates such as ethyl phthalate and n-butyl phthalate and phosphates such as tricresyl phosphate. The low-boiling organic solvents are those having a boiling point between about 30 °C and about 150 °C, for example, lower alkylacetates such as ethyl acetate and butyl acetate. These high and low-boiling organic solvents may be used in admixture. The thus dissolved developing agent can be dispersed in hydrophilic colloid by any of well-known techniques.

When the developing agent is added to any one or more of the layers of the lithographic printing material according to the invention, it can be added directly to the layer. Alternatively, its solution is added to gelatin or synthetic polymers such as polyvinyl alcohol and polyvinyl pyrrolidone as well as alkyl acrylates, sulfoalkyl acrylates and copolymers of acrylic acid as described in USP 3,488,708.

On alkali activation treatment of the offset printing material of the invention after exposure, there may be used treating solutions containing various compounds. Typical additives include alkaline agents (e.g., hydroxides, carbonates and phosphates of alkali metals and ammonium), pH adjusting or buffering agents (e.g., weak acids such as acetic acid and sulfuric acid, weak bases, and salts thereof), development accelerators (for example, pyridinium compounds and cationic compounds as described in USP 2,648,604 and 3,671,247, potassium nitrate and sodium nitrate, polyethylene glycol condensates and derivatives thereof as described in USP 2,533,990, 2,577,127, and 2,950,970, nonionic compounds such as polythio ethers as typified by the compounds described in UKP 1,020,032 and 1,020,033, polymers having a sulfite ester as typified by the compounds described in USP 3,068,097, organic amines such as pyridine, ethanol amine and cyclic amines, benzyl alcohol, and hydrazines), antifoggants (for example, alkali chlorides, alkali bromides, alkali iodides, nitrobenzimidazoles as described in USP 2,496,940 and 2,656,271, mercaptobenzimidazole, 5-methylbenzotriazole, and 1-phenyl-5-mercaptotetrazole, compounds for rapid processing solutions as described in USP 3,113,864, 3,342,596, 3,295,976, 3,615,522, and 3,597,199, thiosulfonyl compounds as described in UKP 972,211, phenazine-N-oxides as described in JP-B 41675/1971, and fog suppressing agents as described in "Scientific Photography Manual", Mid Volume, pages 29-47), anti-stain or sludge agents as described in USP 3,161,513, 3,161,514, UKP 1,030,442, 1,144,481 and 1,251,558, and preservatives (for example, sulfites, acidic sulfites, hydroxylamine hydrochloride, formsulfite, and alkanolamine sulfite adducts). Also useful are metal blocking agents such as sodium hexametaphosphate and ethylenediaminetetraacetic acid and humectants such as saponin and ethylene glycol.

Further contained in the developer are silver halide solvents such as sodium thiosulfate, sodium thiocyanate, potassium thiocyanate, alkanol amines, cyclic imines, alkyl-substituted aminoalcohols, thiourea, meso-ionic compounds, thiosalicylic acid, and compounds capable of generating thiosalicylic acid in alkaline solution, such as 5-methylcarbamoylthiosalicylic acid.

If it is desired to stop development after the offset printing material of the present invention is developed, a neutralizing solution is used. The neutralizing solution may be a conventional acidic stop bath, typically adjusted at pH 3.0 to 8.0. The neutralizing solution may contain a water softening agent, pH adjusting agent, buffer agent and hardener while colloidal silica or polyols may be added for the purpose of avoiding ink staining of the printing plate being processed therewith.

The printing material is processed as described above to obtain a printing plate which is post-treated in various ways for the purpose of improving the printability thereof. For improving ink receptivity, for example, the printing plate may be treated by the methods described in USP 3,592,647, 3,490,906, and 3,161,508, and JP-B 10910/1971, 29723/1973, 15762/1976, and 15762/1977.

## EXAMPLE

Examples of the present invention are given below by way of illustration and not by way of limitation.

### Example 1

#### Preparation of emulsions

#### Emulsion A

To a gelatin aqueous solution kept at 50°C was added citric acid. Then silver nitrate and halide solutions were added thereto over 60 minutes by a controlled double jet technique in the presence of ammonium iridium chloride and a thioether ($HOCH_2CH_2SCH_2$-$CH_2SCH_2CH_2OH$), obtaining a monodisperse emulsion of cubic silver bromide having a grain size of 0.3 µm. After desalting by a flocculation technique, gelatin was added to the emulsion which was heated at 60°C. Thereafter, sodium thiosulfate and tetrachloroauric acid tetrahydrate were added to the emulsion for chemical sensitization. There was obtained a surface latent image type silver halide emulsion A.

#### Emulsion B

To a gelatin aqueous solution kept at 50°C was added citric acid. Then silver nitrate and halide solutions were added thereto over 60 minutes by a controlled double jet technique in the presence of a thioether ($HOCH_2CH_2SCH_2$-$CH_2SCH_2CH_2OH$), obtaining a monodisperse emulsion of cubic silver bromide having a grain size of 0.3 µm. After desalting by a flocculation technique, gelatin was added to the emulsion which was heated at 65°C. Thereafter, formamidine sulfinic acid and tetrachloroauric acid were added to the emulsion which was ripened and then cooled down. There was obtained an emulsion B.

#### Emulsion C

With vigorous stirring, an aqueous solution of potassium bromide and an aqueous solution of silver nitrate were concurrently added to an aqueous gelatin solution at 75°C over 5 minutes in the presence of 1,8-dihydroxy-3,6-dithiaoctane solvent, obtaining an emulsion of octahedral silver bromide having a mean grain size of 0.15 µm. After the emulsion was adjusted to pAg 8.20, sodium thiosulfate and chloroauric acid tetrahydrate, each 115 mg per mol of Ag, were added to the emulsion, which was heated a 75°C for 50 minutes for chemical sensitization. A shell was formed on the thus obtained silver bromide grains serving as the core by adding the solutions to the emulsion over 40 minutes under the same precipitation environment

as in the first precipitation, but in the presence of ammonium iridium (IV) chloride while controlling the pAg of the emulsion at 7.50, thereby allowing the grains to further grow. There was eventually obtained a monodisperse emulsion of cubic core/shell silver bromide having a mean grain size of 0.3 µm (Ir $2.1 \times 10^{-8}$ mol/mol of Ag). After water washing and desalting, sodium thiosulfate and chloroauric acid tetrahydrate, each 3.4 mg per mol of Ag, were added to the emulsion, which was heated at 75°C for 60 minutes for chemical sensitization. There was obtained an internal latent image type silver halide emulsion C.

Production of positive lithographic printing plates

A pre-treated polyester film support on one surface was coated with a matte layer containing silica particles having a mean particle size of 5 µm. The support on the other surface was coated with an anti-halation undercoat layer containing 20 $mg/m^2$ of carbon black (CB) and 20% by weight based on the photographic gelatin of silica powder having a mean particle size of 7 µm and a layer of emulsion A to which $5.0 \times 10^{-4}$ mol/mol of Ag of a sensitizing dye (A). The undercoat layer contained 3.1 $g/m^2$ of gelatin, and the emulsion layer contained 1.5 $g/m^2$ of gelatin and had a silver coverage of 1.5 $g/m^2$. On the emulsion layer, a carboxymethyl cellulose solution containing PdS nuclei as physical development nuclei was coated and dried, obtaining a lithographic printing plate sample A-1.

Lithographic printing plate samples A-2 to A-5 were similarly fabricated by replacing the carbon black in A-1 by solid disperse dyes dispersed in gelatin according to the present invention as shown in Table 1.

Sensitizing dye (A):

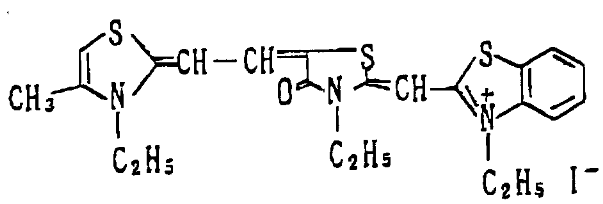

Production of negative lithographic printing plates

A pre-treated polyester film support on one surface was coated with a matte layer containing silica particles having a mean particle size of 5 µm. The support on the other surface was coated with an anti-halation undercoat layer containing 20 $mg/m^2$ of carbon black and 20% by weight based on the photographic gelatin of silica powder having a mean particle size of 7 µm and a layer of emulsion B to which $5.2 \times 10^{-4}$ mol/mol of Ag of a desensitizing dye (B). The undercoat layer contained 3.1 $g/m^2$ of gelatin, and the emulsion layer contained 1.5 $g/m^2$ of gelatin and had a silver coverage of 1.8 $g/m^2$. On the emulsion layer, a carboxymethyl cellulose solution containing PdS nuclei as physical development nuclei was coated and dried, obtaining a lithographic printing plate sample B-1.

Lithographic printing plate samples B-2 to B-5 were similarly fabricated by replacing the carbon black in B-1 by solid disperse dyestuffs dispersed in gelatin according to the present invention as shown in Table 1.

Desensitizing dye (B):

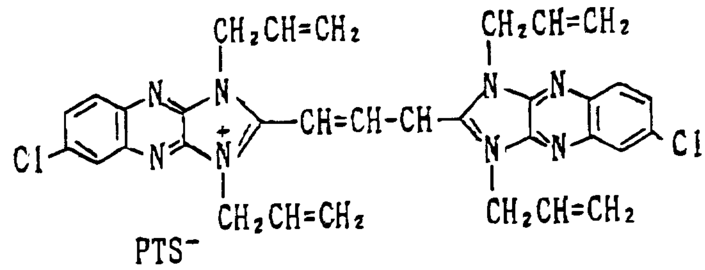

## Production of negative lithographic printing plates

A pre-treated polyester film support on one surface was coated with a matte layer containing silica particles having a mean particle size of 5 µm. The support on the other surface was coated with an anti-halation undercoat layer containing 20 mg/$m^2$ of carbon black and 20% by weight based on the photographic gelatin of silica powder having a mean particle size of 7 µm and a layer of emulsion C to which $5x10^{-4}$ mol/mol of Ag of a desensitizing dye (C) and $4x10^{-6}$ mol/mol of Ag of a nucleating agent (D). The undercoat layer contained 3.1 g/$m^2$ of gelatin, and the emulsion layer contained 1.7 g/$m^2$ of gelatin and had a silver coverage of 2.0 g/$m^2$. On the emulsion layer, a carboxymethyl cellulose solution containing PdS nuclei as physical development nuclei was coated and dried, obtaining a lithographic printing plate sample C-1.

Lithographic printing plate samples C-2 to C-5 were similarly fabricated by replacing the carbon black in C-1 by solid disperse dyestuffs dispersed in gelatin according to the present invention as shown in Table 1.

Sensitizing dye (C):

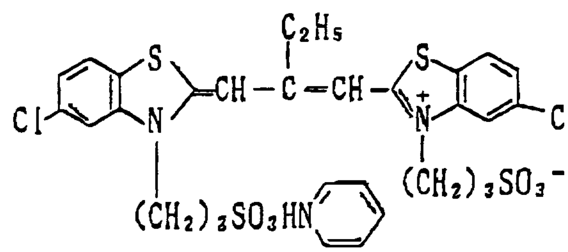

Nucleating agent (D):

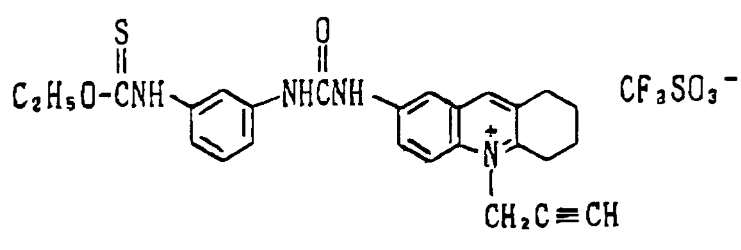

These lithographic printing plates (A-1 to A-5, B-1 to B-5, and C-1 to C-5) were exposed to helium-neon laser light having a wavelength of 633 nm for $10^{-5}$ second through a neutral gray wedge in close contact

with each plate.

Each of the lithographic printing plates was treated with a developer X at 30 °C for 30 seconds and then with a developer Y at 30 °C for 30 seconds, removed of extra developer liquid, immediately thereafter treated with a neutralizing solution at 25 °C for 30 seconds, removed of extra solution through squeeze rollers, and dried at room temperature. The compositions of developers X and Y and neutralizing solution are shown below.

| Developer X | |
|---|---|
| Water | 700 ml |
| Sodium hydroxide | 15 g |
| Sodium sulfite anhydride | 30 g |
| Hydroquinone | 20 g |
| 4-hydroxymethyl-4-methyl-1-phenyl-3-pyrazolidone | 2 g |
| 5-methylbenzotriazole | 0.2 g |
| 2-mercaptobenzimidazole-5-sulfonic acid | 0.2 g |
| KBr | 0.5 g |
| Water totaling to | 1 liter |
| pH | 11.0 |

Developer Y

| | |
|---|---|
| Water | 700 ml |
| Sodium hydroxide | 20 g |
| Sodium sulfite anhydride | 50 g |

| | | |
|---|---|---|
| Hydroquinone | | 26 g |
| 4-hydroxymethyl-4-methyl-1-phenyl-3-pyrazolidone | | 2 g |
| 2-mercaptobenzoic acid | | 2 g |
| Compound (a)* | | 1 g |
| Compound (b)** | | 20 g |
| 2-(2-aminoethylamino)ethanol | | 5 g |
| Water | totaling to | 1 liter |
| | pH | 11.0 |

* Compound (a)

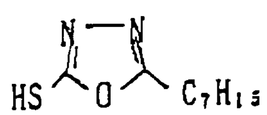

** Compound (b)

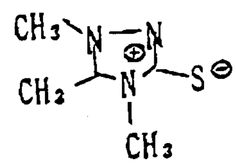

| Neutralizing solution | |
|---|---|
| Water | 600 ml |
| Citric acid | 11 g |
| Sodium citrate | 36 g |
| Colloidal silica (20% solution) | 6 ml |
| Ethylene glycol | 6 ml |
| Water totaling to | 1 liter |

The lithographic printing plates were evaluated for printing properties in terms of resolving power and run length.

The resolving power was examined by using gray contact screens of 100, 133, 150, 175 and 200 lines/inch and determining the line number of the screen at which a fine network image (5% dot) could be clearly reproduced. The resolving power was evaluated in five ratings from rating 1 (100 lines/inch) to rating 5 (200 lines/inch).

Each lithographic printing plate prepared using a contact screen was mounted in an offset printing machine, and a desensitizing solution of the following composition was spread throughout the plate surface. The machine was operated for printing while dampening the plate with a fountain solution of the following composition.

| Desensitizing solution | |
|---|---|
| Water | 550 ml |
| Isopropyl alcohol | 450 ml |
| Ethylene glycol | 50 g |
| Compound (a) | 1 g |

| Fountain solution | |
|---|---|
| o-phosphoric acid | 10 g |
| Nickel nitrate | 5 g |
| Sodium sulfite | 5 g |
| Ethylene glycol | 100 g |
| Colloidal silica (20% solution) | 28 g |
| Water totaling to | 2 liters |

The offset press was A. B. Dick 350CD (trade mark, by A. B. Dick Company). The run length or plate wear was evaluated in accordance with the following criterion based on the number of sheets at which scumming occurred or silver skips disabled printing.

Run length criterion

| | |
|---|---|
| 1 | up to 4,000 sheets |
| 2 | 4,001 to 6,000 sheets |
| 3 | 6,001 to 8,000 sheets |
| 4 | 8,001 to 10,000 sheets |
| 5 | more than 10,000 sheets |

The results are shown in Table 1.

Table 1

| Lithographic printing plate | Dyestuff Type | Amount ($mg/m^2$) | Resolving power | Run length |
|---|---|---|---|---|
| A-1 | CB | 200 | 3 | 3 |
| A-2 | VI-7 | 70 | 5 | 5 |
| A-3 | VI-9 | 100 | 5 | 5 |
| A-4 | VI-17 | 100 | 5 | 5 |
| A-5 | VI-19 | 70 | 5 | 5 |
| B-1 | CB | 200 | 3 | 3 |
| B-2 | VI-7 | 70 | 5 | 5 |
| B-3 | VI-9 | 100 | 5 | 5 |
| B-4 | VI-17 | 100 | 5 | 5 |
| B-5 | VI-19 | 70 | 5 | 5 |
| C-1 | CB | 200 | 3 | 3 |
| C-2 | VI-7 | 100 | 5 | 5 |
| C-3 | VI-9 | 70 | 5 | 5 |
| C-4 | VI-17 | 100 | 5 | 5 |
| C-5 | VI-19 | 100 | 5 | 5 |

It is evident from Table 1 that excellent printing properties (resolving power and run length) result from the use of solid disperse dyestuffs in smaller amounts according to the invention.

Example 2

Lithographic printing plate samples A-6 to A-14, B-6 to B-14, and C-6 to C-14 were prepared by the same procedure as in Example 1 except that the carbon black in A-1, B-1, and C-1 was replaced by solid disperse dyestuffs dispersed in gelatin according to the present invention as shown in Table 2.

Sensitizing dye (A) was changed to $5x10^{-4}$ mol of sensitizing dye (E), desensitizing dye (B) was changed to $5.2x10^{-4}$ mol of desensitizing dye (F), sensitizing dye (C) was changed to $5x10^{-4}$ mol of sensitizing dye (G), all per mol of Ag, and the carbon black was replaced by solid disperse dyestuffs.

Desensitizing dye (E):

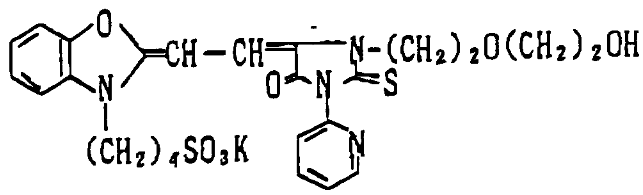

Desensitizing dye (F):

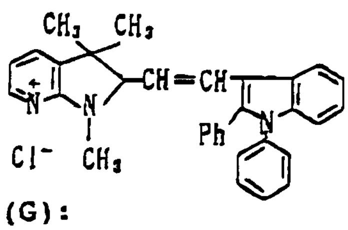

Sensitizing dye (G):

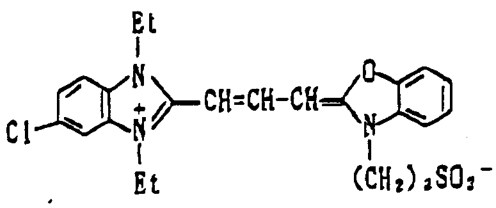

These lithographic printing plate samples were exposed to argon ion laser light having a wavelength of 488 nm for $10^{-5}$ second through a neutral gray wedge in close contact with each plate, processed as in Example 1, and then evaluated for resolving power and run length using the game printing press as in Example 1.

Table 2

| Lithographic printing plate | Dyestuff Type | Amount ($mg/m^2$) | Resolving power | Run length |
|---|---|---|---|---|
| A-1 | CB | 200 | 3 | 3 |
| A-6 | I-16 | 50 | 5 | 5 |
| A-7 | I-17 | 100 | 5 | 5 |
| A-8 | II-3 | 70 | 5 | 5 |
| A-9 | III-3 | 100 | 5 | 5 |
| A-10 | III-9 | 100 | 5 | 5 |
| A-11 | III-29 | 70 | 5 | 5 |
| A-12 | III-31 | 50 | 5 | 5 |
| A-13 | IV-7 | 100 | 5 | 5 |
| A-14 | V-1 | 70 | 5 | 5 |
| B-1 | CB | 200 | 3 | 3 |
| B-6 | I-16 | 50 | 5 | 5 |
| B-7 | I-17 | 100 | 5 | 5 |
| B-8 | II-3 | 70 | 5 | 5 |
| B-9 | III-3 | 100 | 5 | 5 |
| B-10 | III-9 | 80 | 5 | 5 |
| B-11 | III-29 | 100 | 5 | 5 |
| B-12 | III-31 | 70 | 5 | 5 |
| B-13 | IV-7 | 50 | 5 | 5 |
| B-14 | V-1 | 100 | 5 | 5 |
| C-1 | CB | 200 | 3 | 3 |
| C-6 | I-16 | 50 | 5 | 5 |
| C-7 | I-17 | 100 | 5 | 5 |
| C-8 | II-3 | 70 | 5 | 5 |
| C-9 | III-3 | 100 | 5 | 5 |
| C-10 | III-9 | 70 | 5 | 5 |
| C-11 | III-29 | 70 | 5 | 5 |
| C-12 | III-31 | 100 | 5 | 5 |
| C-13 | IV-7 | 70 | 5 | 5 |
| C-14 | V-1 | 100 | 5 | 5 |

It is evident from Table 2 that excellent resolving power and run length result from the use of solid disperse dyestuffs according to the invention in smaller amounts than conventional carbon black.

Example 3

Preparation of Emulsions D, E and F

The grain formation of Emulsion A in Example 1 was repeated except that the halogen composition was changed, obtaining 0.3-$\mu$m cubic monodisperse emulsions of $AgBr_{60}Cl_{40}$,$AgCl_{80}Br_{20}$, and AgCl. Following water washing and desalting, gelatin gas added to the emulsion. Then sodium thiosulfate and tetrachloroauric acid tetrahydrate were added to the emulsion at 60 °C for chemical sensitization. There were obtained surface latent image type emulsions D, E and F.

Preparation of Emulsions G, H and I

The grain formation of Emulsion B in Example 1 was repeated except that the halide composition was changed, obtaining 0.3-$\mu$m cubic monodisperse emulsions of $AgBr_{60}Cl_{40}$,$AgCl_{80}Br_{20}$, and $AgCl_{95}Br_5$. Following water washing and desalting, gelatin was added to the emulsion. Then formamidine sulfinic acid and tetrachloroauric acid tetrahydrate were added to the emulsion at 65 °C, which was ripened and then cooled down. There were obtained emulsions G, H and I.

Preparation of Emulsions J, K and L

After the core formation of Emulsion C in Example 1, the second precipitation was carried out in the same manner except

It is evident from Table 2 that excellent resolving power and run length result from the use of solid disperse dyestuffs according to the invention in smaller amounts than conventional carbon black.

Example 3

Preparation of Emulsions D, E and F

The grain formation of Emulsion A in Example 1 was repeated except that the halogen composition was changed, obtaining 0.3-$\mu$m cubic monodisperse emulsions of $AgBr_{60}Cl_{40}$,$AgCl_{80}Br_{20}$, and AgCl. Following water washing and desalting, gelatin was added to the emulsion. Then sodium thiosulfate and tetrachloroauric acid tetrahydrate were added to the emulsion at 60 °C for chemical sensitization. There were obtained surface latent inage type emulsions D, E and F.

Preparation of Emulsions G, H and I

The grain formation of Emulsion B in Example 1 was repeated except that the halide composition was changed, obtaining 0.3-$\mu$m cubic monodisperse emulsions of $AgBr_{60}Cl_{40}$,$AgCl_{80}Br_{20}$, and $AgCl_{95}Br_5$. Following water washing and desalting, gelatin was added to the emulsion. Then formamidine sulfinic acid and tetrachloroauric acid tetrahydrate were added to the emulsion at 65 °C, which was ripened and then cooled down. There were obtained emulsions G, H and I.

Preparation of Emulsions J, K and L

After the core formation of Emulsion C in Example 1, the second precipitation was carried out in the same manner except that the halogen composition was changed. There were obtained internal latent image type emulsions J, K and L of $AgBr_{80}Cl_{20}$,$AgBr_{60}Cl_{40}$, and $AgBr_{40}Cl_{60}$.

Fabrication of lithographic printing plates

Positive lithographic printing plate samples D-3, E-3, and F-3 were fabricated by the same procedure as printing plate A-3 except that emulsion A was replaced by emulsions D, E, and F.

Negative lithographic printing plate samples G-3, H-3, and I-3 were fabricated by the same procedure as printing plate B-3 except that emulsion B was replaced by emulsions G, H, and I.

Negative lithographic printing plate samples J-3, K-3, and L-3 were fabricated by the same procedure as printing plate C-3 except that emulsion C was replaced by emulsions J, K, and L.

Comparative lithographic printing plate samples D-1 to L-1 were fabricated by the same procedure as lithographic printing plate samples D-3 to L-3 except that carbon black was used as in A-1 instead of the dyestuff in D-3 to L-3.

As in Example 1, these lithographic printing plate samples were exposed, processed and evaluated for resolving power and run length. The results are shown in Table 3.

Table 3

| Lithographic printing plate | Halogen composition | Resolving power | Run length | Remarks |
|---|---|---|---|---|
| D-3 | $AgBr_{60}Cl_{40}$ | 5 | 5 | Invention |
| E-3 | $AgCl_{80}Br_{20}$ | 5 | 5 | Invention |
| F-3 | AgCl | 5 | 5 | Invention |
| G-3 | $AgBr_{60}Cl_{40}$ | 5 | 5 | Invention |
| H-3 | $AgCl_{80}Br_{20}$ | 4 | 4 | Invention |
| I-3 | $AgCl_{95}Br_{5}$ | 3 | 3 | Invention |
| J-3 | $AgBr_{80}Cl_{20}$ | 5 | 5 | Invention |
| K-3 | $AgBr_{60}Cl_{40}$ | 4 | 4 | Invention |
| L-3 | $AgBr_{40}Cl_{60}$ | 4 | 4 | Invention |
| D-1 | $AgBr_{60}Cl_{40}$ | 2 | 2 | CB comparison |
| E-1 | $AgCl_{80}Br_{20}$ | 1 | 1 | CB comparison |
| F-1 | AgCl | 1 | 1 | CB comparison |
| G-1 | $AgBr_{60}Cl_{40}$ | 2 | 2 | CB comparison |
| H-1 | $AgCl_{80}Br_{20}$ | 1 | 1 | CB comparison |
| I-1 | $AgCl_{95}Br_{5}$ | 1 | 1 | CB comparison |
| J-1 | $AgBr_{80}Cl_{20}$ | 2 | 2 | CB comparison |
| K-1 | $AgBr_{60}Cl_{40}$ | 1 | 1 | CB comparison |
| L-1 | $AgBr_{40}Cl_{60}$ | 1 | 1 | CB comparison |

It is evident from Table 3 that for various halogen compositions, the use of solid disperse dyestuffs according to the invention ensures better resolving power and run length than carbon black.

Example 4

In fabricating lithographic printing plates A-1 to A-4, D-3, E-3, F-3, D-1, E-1, and F-1, hydroquinone and 1-phenyl-3-pyrazolidonewere added to the emulsion layer to obtain positive lithographic printing plates. They were exposed as in Example 1, treated with an activator of the following composition, and then evaluated for printing properties as in Example 1. The results are shown in Table 4.

| Activator | |
|---|---|
| 2-(2-aminoethylamino)ethanol | 21 g |
| Uracil | 5 g |
| Thiosalicylic acid | 0.1 g |
| $Na_2SO_3$ | 70 g |
| $Na_2CO_3$ | 15 g |
| KOH | 40 g |
| Compound (a) | 0.4 g |
| Water totaling to | 1 liter |
| pH | 13.7 |

Table 4

| | Halogen composition | Dyestuff | Resolving power | length | Remarks |
|---|---|---|---|---|---|
| A-1 | AgBr | CB | 1 | 1 | Comparison |
| A-2 | AgBr | VI-7 | 3 | 3 | Invention |
| A-3 | AgBr | VI-9 | 3 | 3 | Invention |
| A-4 | AgBr | VI-17 | 3 | 3 | Invention |
| D-1 | $AgBr_{60}Cl_{40}$ | CB | 1 | 1 | Comparison |
| E-1 | $AgBr_{80}Cl_{20}$ | CB | 1 | 1 | Comparison |
| F-1 | AgCl | CB | 1 | 1 | Comparison |
| D-3 | $AgBr_{60}Cl_{40}$ | VI-9 | 3 | 3 | Invention |
| E-3 | $AgBr_{80}Cl_{20}$ | VI-9 | 3 | 3 | Invention |
| F-3 | AgCl | VI-9 | 3 | 3 | Invention |

It is evident from Table 4 that for activator treatment, the solid disperse dyestuffs according to the invention result in better resolving power and run length than carbon black.

There has been described a lithographic printing material adapted for silver salt diffusion transfer comprising an undercoat layer containing a solid particle dispersion of a dyestuff, which contributes to an improvement in resolving power and run length over conventional carbon black.

## Claims

**1.** A lithographic printing material utilized for silver salt diffusion transfer comprising at least an undercoat layer, a silver halide emulsion layer, and a physical development nucleus layer on a support, characterized in that said undercoat layer contains a solid particle dispersion of a dyestuff.

**2.** A lithographic printing material according to claim 1 wherein said dyestuff is at least one compound selected from compounds of the following formulae (I) through (VII):

(I)

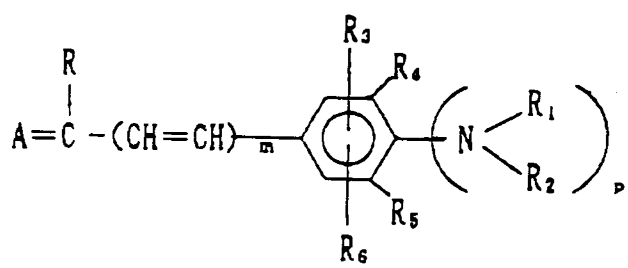

(II)

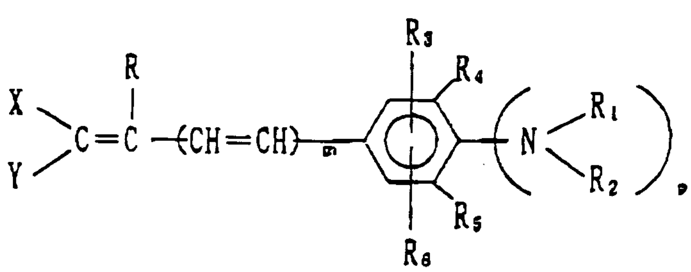

(III) $A = L_1\text{-}(L_2 = L_3)_n\text{-}A'$

(IV) $A = (L_2\text{-}L_3)_{2-q} = B$

(V) 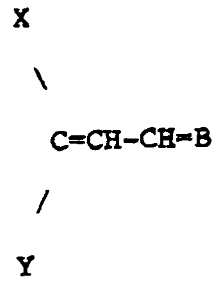

wherein each of A and A' is an acidic nucleus,

B is a basic nucleus,

each of X and Y is an electron attractive group,

R is a hydrogen atom or alkyl group,

$R_1$ and $R_2$ are independently selected from the group consisting of an alkyl, aryl, acyl and sulfonyl group, or $R_1$ and $R_2$ taken together form a five or six-membered ring,

$R_3$ and $R_6$ are independently selected from the group consisting of a hydrogen atom, alkyl group, hydroxyl group, carboxyl group, alkoxy group and halogen atom,

each of $R_4$ and $R_5$ is a hydrogen atom, or

$R_1$ and $R_4$ or $R_2$ and $R_5$ taken together represent a group of non-metallic atoms necessary to form a five or six-membered ring,

each of $L_1$, $L_2$, and $L_3$ is a methine group,

letter m is equal to 0 or 1, n is equal to 0, 1 or 2, p is equal to 0 or 1, and q is equal to 0, 1 or 2, with the proviso that when p is 0, $R_3$ is a hydroxyl or carboxyl group and $R_4$ and $R_5$ are hydrogen atoms,

(VI) 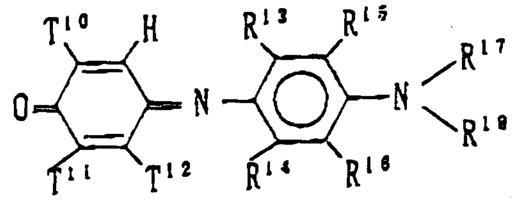

wherein $T^{10}$, $T^{11}$, and $T^{12}$ are independently selected from the group consisting of a hydrogen atom, halogen atom, cyano, nitro, carboxyl, alkyl, aryl, alkoxy, aryloxy, alkylthio, arylthio, alkylsulfonyl, arylsulfonyl, sulfamoyl, carbamoyl, amino, sulfonamido, carbonamido, ureido, sulfamido, hydroxy, vinyl, and acyl group,

$R^{13}$ and $R^{14}$ are independently selected from the group consisting of a hydrogen atom, halogen atom, alkoxy, alkyl, alkenyl, aryloxy, and aryl group,

each of $R^{15}$ and $R^{16}$ is a hydrogen atom or a group substituting therefor,

$R^{17}$ and $R^{18}$ are independently selected from the group consisting of an alkyl, aryl, vinyl, acyl, alkylsulfonyl, and arylsulfonyl group, or

each pair of $T^{11}$ and $T^{12}$, $R^{13}$ and $R^{15}$, $R^{14}$ and $R^{16}$, $R^{17}$ and $R^{18}$, $R^{15}$ and $R^{17}$, and $R^{16}$ and $R^{18}$, taken together, form a ring,

(VII) 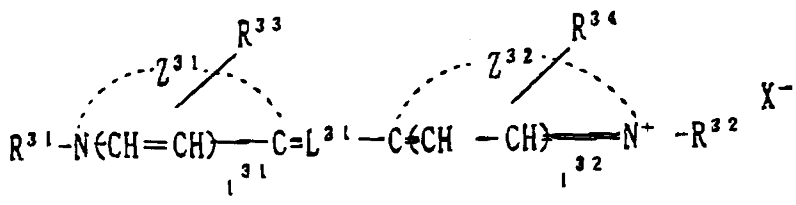

wherein each of $R^{31}$ and $R^{32}$ is an alkyl, alkenyl or aryl group,

each of $R^{33}$ and $R^{34}$ is a hydrogen atom or a monovalent group,

each of $Z^{31}$ and $Z^{32}$ is a group of non-metallic atoms necessary to form a five or six-membered

nitrogenous heterocyclic ring,

$L^{31}$ is a linkage of five to seven methine groups concatenated through conjugated double bonds,

$X^-$ is an anion, and

each of $l^{31}$ and $l^{32}$ is equal to 0 or 1.